(19) Europäisches Patentamt
European Patent Office
Office européen des brevets

(11) **EP 4 742 543 A1**

(12) **EUROPEAN PATENT APPLICATION**

(43) Date of publication:
**13.05.2026 Bulletin 2026/20**

(51) International Patent Classification (IPC):
**H03M 7/30** *(2006.01)*   **H04B 14/00** *(2006.01)*

(21) Application number: **24211763.8**

(52) Cooperative Patent Classification (CPC):
**H03M 7/3071; H03M 7/3068**

(22) Date of filing: **08.11.2024**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Technische Universität Dresden
Körperschaft des
öffentlichen Rechts
01069 Dresden (DE)**

(72) Inventors:
• **TÖMÖSKÖZI, Máté**
**01067 Dresden (DE)**
• **TAGHOUTI, Maroua**
**01067 Dresden (DE)**

(74) Representative: **Viering, Jentschura & Partner
mbB
Patent- und Rechtsanwälte
Am Brauhaus 8
01099 Dresden (DE)**

(54) **CIRCUITS AND METHODS FOR LOSSLESS COMPRESSION OF SENSOR DATA**

(57) The present disclosure relates to a method (210) of lossless compression of sensor data, the method including: receiving sensor data (216) comprising a plurality of sensor reading values, wherein the sensor data (216) are associated with a corresponding sensor; converting a format for representing the sensor reading values from a first format defined by the corresponding sensor into a second format; providing (220) the sensor reading values as sequenced sensor reading values (218) represented with the second format; selecting (230), from a plurality of predefined predetermined compression profiles (221), a compression profile (222) for carrying out a lossless compression of the sequenced sensor reading values, wherein the compression profile (222) comprises a plurality of compressed data formats (224), wherein each compressed data format (224) defines a respective size of a data slot for transmitting one or more of the sequenced sensor reading values (218); carrying out (240) a lossless compression of the sequenced sensor reading values (218) to obtain compressed sensor reading values, wherein the second format is a data format supported by the lossless compression; and preparing the compressed sensor reading values for transmission using the compressed data formats (224) defined by the compression profile.

FIG. 2A

# Description

## Technical Field

The present disclosure is generally related to a data compression circuit configured to carry out lossless compression of sensor data, to a corresponding circuit configured to carry out decompression of the compressed sensor data, and to methods thereof (e.g., a method of carrying out lossless compression of sensor data, a method of carrying out decompression of the compressed sensor data).

## Background

In general, "Internet of Things (IoT)" refers to networks of interconnected devices that exchange information with one another and with a central data processing system (e.g., a cloud system), at which data from various sources are processed and managed to then provide various services to the network users. IoT devices have various applications, such as for smart household appliances (e.g., a smart lighting system, a smart thermostat, and the like), for industrial machines (e.g., robots to carry out automated tasks), for smart farming systems, for wearable devices that monitor health parameters (e.g., heartbeat, blood pressure, etc.), as examples. In this framework, IoT sensors play an important role in monitoring the environment, collecting data on a certain physical quantity, and reporting the collected data to the data processing system for further action. IoT sensors enable the system to take informed decisions, thus reacting promptly to changes in the environment, e.g., changes in temperature, pressure, illuminance, and the like.

The efficiency of the transmission of sensor data representing the result of a sensing process has thus an influence on the overall performance of the IoT network. However, data compression, which is a practical technique to improve data transmission efficacy, is not well designed to be ran on sensors and handle sensor data. Existing solutions tackle the problem by equipping each type of IoT sensor box either with a dedicated compression solution or with a standard static and common compression solution. The dedicated compression solution may be developed through extensive dedicated experiments, but is not necessarily optimized. The standard compression solution, such as ZIP, may be applied on a cumulative set of values (not in real time). Moreover, the best practice typically is to convert the readings into a text-based JSON (or even XML) representation, which is very wasteful compared to transmitting in the binary format. This approach is however considered obsolete compared to what can be achieved with today's computation toolsets. Improvements in data compression strategies for transfer of sensor data may thus be of particular relevance for the further advancement of IoT technologies.

## Brief Description of the Drawings

In the drawings, like reference characters generally refer to the same parts throughout the different views. The drawings are not necessarily to scale, emphasis instead generally being placed upon illustrating the principles of the invention. In the following description, various aspects of the invention are described with reference to the following drawings, in which:

FIG. 1A shows an IoT architecture in a schematic representation, according to various aspects;
FIG.1B shows a sensor box including a plurality of sensors in a schematic representation, according to various aspects;
FIG.2A shows a data compression circuit in a schematic representation, according to various aspects;
FIG.2B shows a data decompression circuit in a schematic representation, according to various aspects;
FIG.2C shows an exchange of data between a data compression circuit and a data decompression circuit in a schematic representation, according to various aspects;
FIG.3 shows a sequencing process for the data compression in a schematic representation, according to various aspects; and
FIG.4 shows a profiling and compression process for the data compression in a schematic representation, according to various aspects.

## Description

The following detailed description refers to the accompanying drawings that show, by way of illustration, specific details and aspects in which the invention may be practiced. These aspects are described in sufficient detail to enable those skilled in the art to practice the invention. Other aspects may be utilized and structural, logical, and electrical changes may be made without departing from the scope of the invention. The various aspects are not necessarily mutually exclusive, as some aspects may be combined with one or more other aspects to form new aspects. Various aspects are described in connection with methods and various aspects are described in connection with devices (e.g., a data compression circuit, a sensor, a sensor box, a data decompression circuit, etc.). However, it is understood that aspects described in connection with methods may similarly apply to the devices, and vice versa.

In general, sensors are a key part of an IoT architecture, as they allow the network to have a constantly updated understanding of the environment, thus enabling the network to take appropriate actions in a timely manner. Illustratively, a sensor may monitor fluctuations and changes of a certain physical quantity, and may report the results of the measurement to a processing layer of the IoT architecture, which may then instruct a corresponding adaptation of the operation of one or more IoT devices. For example, in case the sensor data indicate that the temperature in a room fell below a temperature threshold, the IoT system may instruct turning on a heater of a smart heating system of the house. As another example, in case the sensor data indicate that the ambient brightness is above a brightness threshold, the IoT system may instruct turning off one or more lights of a smart lighting system of the house, and the like. Thus, in the IoT context, sensor data enable the identification of the optimal response in a given scenario, and facilitate the automated execution of tasks that would otherwise require human intervention. Illustratively, sensors are the bridge between the analog and the digital world, unified in a cyber-physical system.

In this framework, the transmission of sensor data is a critical task, which generally requires data compression to allow handling and transmitting large amounts of collected data (e.g., large amounts of data points collected over a certain period of time). However, existing solutions for data compression suffer from several shortcomings. For example, conventional approaches may achieve relatively limited compression ratios, and may in general be not aware of the network conditions. As a further example, conventional approaches may be implemented for "batched" data transmission rather than real-time, and may thus require a relatively large memory space. As a further example, conventional approaches may have a relatively slow compression and decompression speed due to the complexity of the algorithms, which limits the feasibility on power- and computation-constrained devices like IoT sensor boxes. As another example, conventional approaches may be designed for a specific type of sensor, and may thus be application dependent, without the flexibility for handling sensor data originating from different sensor types. As a further example, conventional approaches may bring extra overhead, as they rely on multiple packet headers when transmitting (e.g., IP, UDP and RTP for real-time video, as an example).

The present disclosure is related to an adapted approach for compression of sensor data, which is designed to facilitate sensor data exchange (transmission) towards an end destination at which the sensor data are used for decision-making. In particular, the proposed approach may be based on the realization that a more time- and resource-efficient data compression may be obtained by first changing the representation of the sensor data from the initial raw format into a format that facilitates the subsequent compression, and then by introducing a dynamic selection of compressed data formats for transmitting the data.

The proposed compression may thus be understood as a dynamic and adaptive process, in which the process parameters are selected based on the data to be compressed. As an initial step, the conversion of the representation of the sensor data may be dynamically adapted based the most suitable conversion approach for the specific raw format of the data. As a subsequent step, the selection of the compressed data formats may take into consideration the behavior of the sensor data, to identify which data format or which combination of data formats is the most suitable for transmitting the currently available sensor data.

The lossless compression of sensor data may thus be based on defining a more suitable representation of the data, and then on identifying suitable compressed data packets for the data transmission. In particular, the identification of the data packets may be based on exploiting the behavior of the sensor data to flexibly adapt the size of a data slot of the data packets.

In the proposed strategy the data compression is tailored to the actual characteristics of the sensor data to be compressed. This approach may enable massive and fast real-time sensor data processing and communication at reduced costs and higher robustness. Furthermore, the proposed data compression may be independent of the hardware used, e.g., may be independent of the type of sensor from which the sensor data originated. As a further example, the proposed strategy may enable an energy-efficient utilization of the communication medium, as well as optimized storage, and scalability in the sense that allows handling large volumes of data from different sensors.

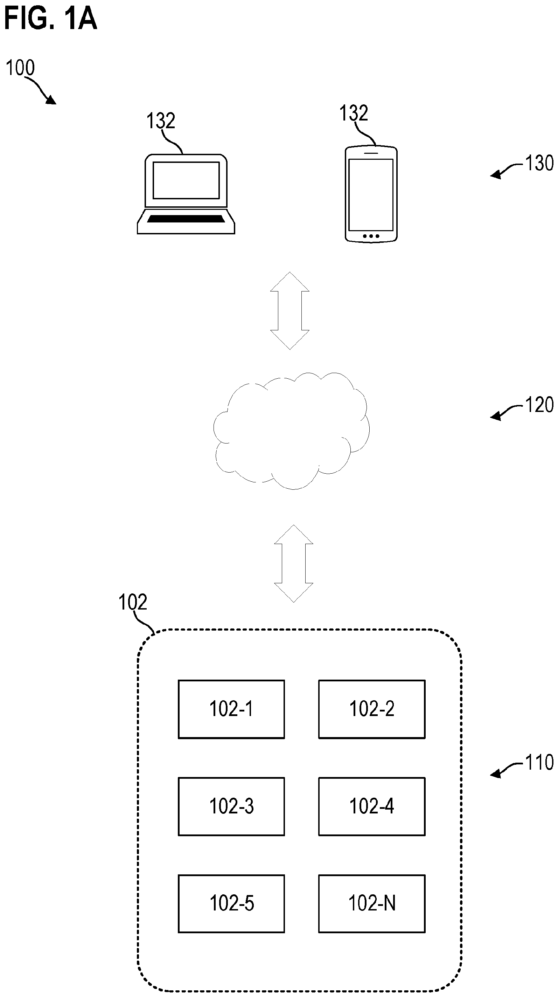

The following examples pertain to various aspects of the present disclosure, and refer to the aspects discussed in the following and illustrated in FIG.1A to FIG.4.

According to various aspects, a method for carrying out lossless compression of sensor data is provided, the method including: receiving sensor data including a plurality of sensor reading values (e.g., a time series of data points), wherein the sensor data are associated with a corresponding sensor; converting a format for representing the sensor reading values from a first format (e.g., a raw format) defined by the corresponding sensor into a predetermined second format (illustratively, the second format may be a standardized format for providing the sensor data as input to the compression); providing the sensor reading values as sequenced sensor reading values represented with the second format; selecting, from a plurality of predefined compression profiles, a compression profile for a lossless compression of the sequenced sensor reading values, wherein the selected compression profile includes a plurality of compressed data formats, wherein each compressed data format has a respective size of a data slot for transmitting one or more of the sequenced sensor reading values; carrying out a lossless compression of the sequenced sensor reading values to obtain compressed sensor reading values, wherein the second format is a data format supported by the lossless compression; and preparing the compressed sensor reading values for transmission using the compressed data formats defined by the compression profile. Illustratively, the method may include preparing the compressed sensor reading values for transmission by providing, according to the compression profile, compressed data packets that contain the compressed sensor reading values. The method described in this paragraph provides a first example.

The method may optionally further include that preparing the compressed sensor reading values for transmission includes providing compressed data packets that contain the compressed sensor reading values according to the compression profile. The features described in this paragraph in combination with the first example provide a second example.

The method may optionally further include causing a transmission of the compressed data packets containing the compressed sensor reading values. The features described in this paragraph in combination with the first example or second example provide a third example.

The method may optionally further include receiving feedback information representative of a quality of a decompression of the compressed sensor reading values; changing one or more parameters associated with the lossless compression of the sensor reading values based on the received feedback information; and carrying out a lossless compression of further sensor data using the changed one or more parameters. The features described in this paragraph in combination with any one of the examples one to three provide a fourth example.

The method may optionally further include that converting a format for representing the sensor reading values includes using a trained machine learning model that receives, as input, the sensor reading values and delivers, as output, a corresponding rule for converting the representation of the sensor reading values into the second format. The features described in this paragraph in combination with any one of the examples one to four provide a fifth example.

The method may optionally further include that selecting the compression profile includes identifying the compressed data formats based on a target data packet size for the compressed data packets and a target robustness of a data transmission of the compressed data packets. The features described in this paragraph in combination with any one of the examples one to five provide a sixth example.

The method may optionally further include that selecting the compression profile includes using a trained machine learning model that receives, as input, the sequenced sensor reading values to be compressed and delivers, as output, the compression profile to be used for the lossless compression of the sequenced sensor reading values. The features described in this paragraph in combination with any one of the examples one to six provide a seventh example.

The method may optionally further include that the sensor data include a plurality of sensor data associated with a plurality of corresponding sensors; and that carrying out the lossless compression of the sequenced sensor reading values includes providing at least one compressed data packet that contains compressed sensor reading values associated with different sensors The features described in this paragraph in combination with any one of the examples one to seven provide an eighth example.

The method for carrying out lossless compression of sensor data may be a computer-implemented method. In various aspects, a computer program (product) may be provided, the computer program (product) including instructions which, when the program is executed by a computer, cause the computer to carry out the method for carrying out lossless data compression, e.g., the method of any one of examples 1 to 8. In various aspects, a non-transitory computer-readable (storage) medium may be provided, the non-transitory computer-readable (storage) medium including instructions which, when executed by a computer, cause the computer to carry out the method for carrying out lossless compression of sensor data, e.g., the method of any one of examples 1 to 8.

A method of decompression of sensor data compressed according to the method of any one of examples 1 to 8 may be provided, the method of decompression including: receiving the plurality of compressed data packets containing the plurality of compressed sensor reading values; and carrying out a decompression of the compressed data packets to reconstruct the sequenced sensor reading values. The method described in this paragraph provides a tenth example.

The method may optionally further include, after the decompression of the compressed data packets, converting the format of the sequenced sensor reading values from the second format into the first format defined by the corresponding sensor. The features described in this paragraph in combination with the tenth example provide an eleventh example.

The method for carrying out decompression of the compressed sensor data may be a computer-implemented method. In various aspects, a computer program (product) may be provided, the computer program (product) including instructions which, when the program is executed by a computer, cause the computer to carry out the method for carrying out decompression of the compressed sensor data, e.g., the method of any one of examples 10 or 11. In various aspects, a non-transitory computer-readable (storage) medium may be provided, the non-transitory computer-readable (storage) medium including instructions which, when executed by a computer, cause the computer to carry out the method for carrying out decompression of the compressed sensor data, e.g., the method of any one of examples 10 or 11.

In a corresponding manner, a data compression circuit may be provided, the data compression circuit including: a sequencer configured to: receive sensor data including a plurality of sensor reading values (e.g., a time series of data points), wherein the sensor data are associated with a corresponding sensor; convert a format for representing the sensor reading values from a first format defined by the corresponding sensor into a predetermined second format; and deliver, as output, the sensor reading values as sequenced sensor reading values represented with the second format; a compressor configured to select, from a plurality of predetermined compression profiles, a compression profile for a lossless compression of the sequenced sensor reading values, wherein the selected compression profile includes a plurality of compressed data formats, wherein each compressed data format defines a respective size of a data slot (e.g., one or more data slots) for transmitting one or more of the sequenced sensor reading values; carry out a lossless compression of the sequenced sensor reading values to obtain compressed sensor reading values, and prepare the compressed sensor reading values for transmission using the compressed data formats defined by the compression profile, wherein the second format is a data format supported by the compressor. Illustratively, the compressor may be configured to prepare the compressed sensor reading values for transmission by providing (e.g., generating) compressed data packets that contain the compressed sensor reading values. The data compression circuit described in this paragraph provides a twelfth example.

The data compression circuit may optionally further include that the compressor is further configured to provide compressed data packets that contain the compressed sensor reading values according to the compression profile. The features described in this paragraph in combination with the twelfth example provide a thirteenth example.

The data compression circuit may optionally further include that the compressor is further configured to cause a transmission of the compressed data packets containing the compressed sensor reading values. The features described in this paragraph in combination with the twelfth example or thirteenth example provide a fourteenth example.

The data compression circuit may optionally further include that the compressor is further configured to: receive feedback information representative of a quality of a decompression of the compressed sensor reading values; change one or more parameters associated with the lossless compression of the sensor reading values based on the received feedback information; and carry out a lossless compression of further sensor data using the changed one or more parameters. The features described in this paragraph in combination with any one of the examples twelve to fourteen provide a fifteenth example.

The data compression circuit may optionally further include that the sequencer is configured to use a trained machine learning model that receives, as input, the sensor reading values and delivers, as output, a corresponding rule for converting the representation of the sensor reading values into the second format. The features described in this paragraph in combination with any one of the examples twelve to fifteen provide a sixteenth example.

The data compression circuit may optionally further include that the compressor is configured to select the compression profile based on a target data packet size for the compressed data packets and a target robustness of a data transmission of the compressed data packets. The features described in this paragraph in combination with any one of the examples twelve to sixteen provide a seventeenth example.

The data compression circuit may optionally further include that the compressor is configured to use a trained machine learning model that receives, as input, the sequenced sensor reading values to be compressed and delivers, as output, the compression profile to be used for the lossless compression of the sequenced sensor reading values. The features described in this paragraph in combination with any one of the examples twelve to seventeen provide an eighteenth example.

The data compression circuit may optionally further include that the sensor data include a plurality of sensor data associated with a plurality of corresponding sensors; and that the compressor is configured to provide at least one compressed data packet that contains compressed sensor reading values associated with different sensors The features described in this paragraph in combination with any one of the examples twelve to eighteen provide a nineteenth example.

According to various aspects, a corresponding data decompression circuit may be provided, the data decompression circuit including a decompressor configured to: receive sensor data compressed according to the data compression method proposed herein; and carry out a decompression of the compressed data packets to reconstruct the sequenced sensor reading values. The data compression circuit described in this paragraph provides a twentieth example.

In a preferred configuration, the data compression may include using a machine learning (ML) model, e.g., for the sequencing of the sensor reading values and/or for identifying the compression profile for the lossless compression of the sequenced sensor reading values. Illustratively, in some aspects the proposed approach may rely on Machine Learning to compress the streams of sensor data on the fly based on the most suitable compression profile dictated by an artificial intelligence (AI) agent that has access to different parameters as well as older sensor data streams to decide the best way to losslessly compress the data in real-time. The proposed approach may thus include using AI to define the compression profiles, an initial sequencing to transform any data into a common format, and a compression based on the profiles and the sequenced sensor data as inputs. The parameters of the ML model may be freely adapted. For example, for the profile the ML model may include N independent variables, and N*M dependent variables, where M is the number of compressed data formats in a profile.

It is however understood that, in principle, the data compression described herein may also be implemented without relying on machine learning or artificial intelligence tools. For example, the data compression may be implemented using algorithms that do not fall under the definition of "machine learning" or, as another example, the data compression may involve an input from a user (e.g., to define or select a rule for converting the format of the sensor data, and/or to define or select the compression profile to be used).

In a preferred configuration, the data compression may be implemented in a sensor box that includes a plurality of sensors. For example, a processing circuit of the sensor box (e.g., integrated or embedded in the sensor box) may be configured to carry out data compression according to the approach described in the present disclosure. For example, the processing circuit may be a dedicated data compression circuit of the sensor box or, as another example, the data compression functionality may be carried out by a processing circuit configured to carry out also additional functions for controlling the overall operation of the sensor box.

The adaptive data compression illustrated herein allows a reliable and efficient transfer of sensor data from the sensor box to an end destination (e.g., a cloud system). For example, the sensor box may be part of an IoT network, and the proposed data compression may facilitate the data transfer to a cloud system of the IoT network (e.g., to an entity in the network layer or processing layer of the IoT architecture). In particular, the proposed strategy facilitates compression of data from different types of sensors, thus providing a hardware-independent approach that may simplify the transfer of data from a sensor box that includes sensors that measure different physical quantities.

According to various aspects, considering the implementation in a network, the data compression may also understand the network, and may generate repair packets or adapt the compression to guarantee predefined reliability criteria. As a further example, the proposed data compression may be carried out with a reduced energy consumption, which may be of particular relevance for wireless IoT sensor boxes that are craving battery life to transmit data wirelessly. In addition, data compression enhances privacy and safety for the data transmission, as the data may be difficult to be understood if breached while in a compressed representation. Additionally, the proposed methodology is itself very lightweight in a way that it guarantees real-time communications under different network infrastructures.

As mentioned, the compression strategy of the present disclosure may be of particular relevance in the framework of IoT networks and IoT sensor boxes, because it allows a time- and resource-efficient transmission of sensor data, thus improving the overall performance of the network (e.g., in terms of reaction time, resource consumption, and the like). Thus, in the present disclosure terminology may be used that pertains to the particular context of IoT networks, IoT sensors, and IoT sensor boxes. It is however understood that, in principle, the data compression described herein is not limited to an implementation in a sensor box and/or to an implementation in the IoT context, and may in general be implemented in any suitable scenario and in any suitable type of device or system in which compression of sensor data for transmission may play a role. In general, the data compression described herein may be applied in any suitable packet-switched network in which data are broken down into packets for transmission.

The term "data" may be used herein to describe information in any suitable analog or digital form. In particular, the term "data" may be used herein in relation to "sensor data" to describe information obtained (directly or indirectly) from a measurement carried out by a corresponding sensor, e.g., from a continuous measurement, an instantaneous measurement, a measurement triggered by a certain event, and the like. The term "sensor data" may be used herein to describe the direct output of the sensor and/or to describe the output of the sensor after initial processing and manipulation.

For example, the term "sensor data" may be used herein to describe information on the physical quantity sensed by the sensor, and obtained directly from the signal output by the transducer (e.g., values representing the physical quantity). As another example, the term "sensor data" may be used herein to describe data originating from the fusion of the outputs of multiple sensors, or to describe derived data obtained indirectly from the information obtained from the measurement by a sensor (illustratively, information representative of another quantity obtained starting from the output of the transducer). For example, sensor data may originate from an analog measurement and may be converted into a digital form for further processing. In this regard, the term "data" or "sensor data" may be used to refer both to the data in analog form and the data in the corresponding digital form.

The term "data" may also describe a reference to information, e.g., in form of a pointer representative of a memory address of a memory location in which the (sensor) data are stored. In general, "data" may take various forms and represent information in any suitable manner as understood in the art.

The term "data packet" may be used herein as generally understood in the art to describe a unit of data formatted into a single package for transmission from a first entity (e.g., a sensor box) to a second entity (e.g., a gateway of the IoT network layer), e.g., over a wired connection or wireless connection. Illustratively, data (e.g., sensor data) to be transmitted from the first entity to the second entity may be split into a plurality of data packets, thus providing smaller units to facilitate handling and transmission over the connection (e.g., over one or more communication channels between the two entities). At the end destination (e.g., the second entity), the data contained in the data packets may be reassembled to reconstruct the original data, as generally known in the art.

A "data packet" may include various fields dedicated to different type of information. For example, a "data packet" may include a header field including information associated with the delivery of the data packet. For example, the header field may include the address of the entity transmitting the data packet, the address of the entity receiving the data packet, the communication protocol used, the packet type, the chosen format, and the like. As a further example, a "data packet" may include a data field including the (actual) data to be transmitted. For example, the data field may be part of a "payload" of the data packet. Optionally, a "data packet" may further include a footer field including information associated with error-checking, e.g., the footer field may include a cyclic redundancy check (CRC) associated with the integrity of the data transmission. The footer field may also be referred to as trailer field. It is understood that the data compression proposed herein may be implemented with "data packets" having any suitable configuration known in the art. A "field" of a data packet may also be referred to herein as "section" or "portion" of the data packet.

The term "data compression" may be used herein as generally understood in the art to describe a process that takes data having a first size as input (e.g., an initial size expressed in bits) and delivers, as output, data having a second size generally smaller than the first size (theoretically, the output may be larger after compression if there is no redundancy in the data, and then compression-related metadata are added). Illustratively, as a result of the data compression, the output data may have a second size that generally has fewer bits compared to the first size of the input data. For example, "data compression" may include varying the representation of the data from a first representation of the input data into a second representation of the output data, wherein the second representation allows representing the information with fewer bits compared to the first representation. In this regard, a "compressed data packet" may refer to a data packet that contains data having a compressed representation. "Data compression" may also be referred to herein simply as "compression".

The term "lossless" may be used herein as generally understood in the art to indicate a compression process that allows a complete reconstruction of the non-compressed data. Illustratively, the term "lossless" may describe a data compression that does not cause loss of information, such that the information contained in the data prior to the compression may be completely retrieved upon decompression of the (losslessly) compressed data. The term "lossless" may refer to the data as input and output of the data compression, independently of previous processing of the data (e.g., independently of previous manipulation of the data, for example for reducing or cancelling noise).

For example, the data prior to the compression may be sensor data that contain the full information provided by a sensor reading (e.g., including noise), and the lossless compression may enable a full reconstruction of the information. As another example, the data prior to the compression may be sensor data on which a noise reduction process was carried out. In this scenario the data prior to the compression include less information compared to the original sensor data (illustratively, less noise), and the lossless compression may enable a full reconstruction of the noise-reduced sensor data. The term "lossless" may be used herein in relation to both scenarios. Illustratively, a data compression circuit considered as a whole (e.g., including noise filtering) may be considered "lossy", for example in case of a very strong parameterization of the filtering. However, the compressor of the data compression circuit (and the compression itself) may be "lossless" in that the data that are input to the compressor may be fully reconstructed at the decompression side.

For example, "lossless data compression" may be based on the identification and exploitation of statistical redundancy in the data to be compressed, which allows representing the data in a compressed manner while allowing a complete reconstruction at the end destination. The term "lossless" may thus describe a reversible process in which the data compression may be reversed to re-obtain the input data. Various algorithms are known in the art for carrying out lossless data compression, such as Huffman coding, Run Length Encoding (RLE), Shannon-Fano compression algorithm, or Lempel-Ziv-Welch (LZW) compression.

The term "sensor" may be used herein to describe a transducer configured to sense a physical quantity. The physical quantity may vary depending on the sensor type, e.g., the physical quantity may be a geometric quantity, a mechanical quantity, a light-related quantity, a chemical quantity, a biological quantity, a thermodynamic quantity, an electrical quantity, or combinations thereof, as examples. A "sensor" may be capable of monitoring a continuous behavior of the physical quantity, e.g., an evolution over time of the physical quantity. This may be the case, for example, for a temperature sensor that monitors the behavior of the temperature over time. As another example, a "sensor" may be capable of distinguishing between two states of the sensed quantity, e.g., an on/off behavior or present/absent behavior. This may be the case, for example, for an occupancy sensor that detects whether a certain room is presently occupied by a person or not. A "sensor" may also be referred to herein as sensor circuit or sensor integrated circuit (sensor IC). The term "detector" may be used herein in a similar manner as the term "sensor".

In some configurations, a physical sensor IC may include more than one sensor type inside it, e.g., one or more main sensors configured to monitor one or more physical quantities for which the sensor IC is designed, and one or more auxiliary sensors that monitor other types of physical quantities to support and complement the measurements of the main sensor(s). An example of this configuration may be a pressure sensor, which may include a built-in temperature sensor to compensate pressure readings. In general, references to "sensor data" from a sensor may refer to data from the main sensor(s) and/or to data from the auxiliary sensor(s), which may be processed (e.g., compressed and transmitted) together or individually depending on the scenario. For example, references to a "plurality of sensor data from a plurality of sensors" may refer to sensor data originating from phyiscally separated sensor ICs, or to sensor data originating from multiple sensors of the same sensor IC.

The term "sensor" may thus be used herein to describe the circuit responsible for the actual sensing process. A "sensor" may have sensing capabilities, but may have limited or no computational capabilities. The term "sensor device" may be used herein to describe a device that includes one or more sensors, and additionally includes processing circuitry to carry out processing and computations on the sensor data. A "sensor device" may thus be configured to carry out a sensing process via the respective sensor (or sensors), and furthermore may be capable of at least partially processing the sensor data. The term "sensor box" may be used herein to describe a sensor device that includes a plurality of sensors, e.g., of different sensor types, and additionally includes processing circuitry and communication circuitry for processing the sensor data and for transmitting the (processed) sensor data. In particular, a sensor device and sensor box described herein may be for use in the IoT context, e.g., may be configured to participate in an IoT architecture (via a connection to the corresponding layers of the IoT architecture). In some aspects, a sensor device and sensor box may thus be configured as IoT sensor device or IoT sensor box, respectively.

As mentioned above, in various aspects the proposed data compression may utilize one or more machine learning models to perform functions associated with the compression of the sensor data. The term "model" may describe any kind of algorithm that provides output data based on input data delivered to the model. In some aspects, parameters of a machine learning model may be defined and/or adjusted during a training phase using training data (e.g., previous sensor data, part of the current sensor data, and the like). A trained machine learning model may be used during an inference phase to make predictions or estimations based on input data (e.g., sensor data to be compressed).

A "machine learning model" may have any suitable structure and may be based on any suitable technique. For example, a "machine learning model" used in the data compression described herein may be based on unsupervised learning, supervised learning, semi-supervised learning, reinforcement learning, or combinations thereof. In some aspects, a "machine learning model" may include a neural network. The neural network may have any suitable architecture with any suitable number of layers, e.g., the neural network may be a recurrent neural network, a convolutional neural network, a deconvolutional network, a generative adversarial network, a sparse autoencoder network, and the like.

**FIG.1A** shows an IoT architecture 100 in a schematic representation, according to various aspects. The IoT architecture 100 shows an exemplary context for the implementation of the data compression proposed herein. It is however understood that the data compression strategy may be carried out also in other types of contexts, systems, or devices. In general, the data compression strategy may be carried out in any system including one or more sensors, e.g., any system including a plurality of sensors. It is also understood that the configuration illustrated in FIG.1A is exemplary, and an IoT architecture 100 may include additional, fewer, or alternative components with respect to those shown. An IoT architecture may also be referred to herein as IoT network or IoT system.

In general, an IoT architecture 100 may include different layers. The exemplary configuration in FIG.1A shows a three-layer architecture including a perception layer 110, a network layer 120, and an application layer 130. In other aspects, the IoT architecture 100 may have a four-layer architecture (e.g., further including a data processing layer between the network layer 120 and the application layer 130), or a five-layer architecture (e.g., further including a business layer above the application layer 130), or any suitable type of architecture and layers. The aspects discussed in relation to a three-layer architecture may apply in a corresponding manner to a four- or five-layer architecture, and vice versa.

The perception layer 110 may be the physical layer of the IoT architecture, and may include a plurality of sensor devices 102 to collect sensor data, e.g., data about one or more physical quantities of interest. The perception layer 110 may include any suitable number of sensor devices 102, e.g., one, two, three, four, five, ten, or more than ten sensor devices 102. In the exemplary configuration in FIG.1A first to n-th sensor devices 102-1 to 102-N are illustrated, but it is understood that the IoT architecture 100 may include more or fewer sensor devices 102. The perception layer 110 may also be referred to as sensing layer.

The role of the perception layer 110 in the IoT architecture 100 may be to obtain data representing the physical world, and the sensor devices 102 may be configured to sense different types of physical quantities (e.g., temperature, pressure, motion, light, and the like) to provide a comprehensive understanding of the environment. Each sensor device 102 may be understood as a "node" in the IoT network.

The network layer 120 may be configured to connect the perception layer 110 with other devices or servers. The network layer 120 may thus include communication components to provide a routing and distribution of the sensor data from the perception layer 110. The network layer 120 may be based on any suitable wired- and/or wireless-communication technology. Exemplary communication technologies may include Bluetooth, wireless local area network (WLAN), WiFi, 5G, 6G, Zigbee, Cellular Network, Serial Peripheral Interface (SPI), Ethernet, and the like. Illustratively, the network layer 120 may provide a communication interface between the perception layer 110 and the layers above (e.g., the application layer 130 in FIG. 1A, or the data processing layer in a four-layer configuration), e.g., to allow the data from the sensor devices 102 to reach the application layer 130. In a four-layer architecture, the network layer 120 may allow transmission of the sensor data to the processing layer. For example, the network layer 120 may include one or more gateways (IoT gateways) configured to receive data from the perception layer 110, and transfer the received data to the above layers in the architecture.

The application layer 130 may use the (processed) sensor data to execute or instruct applications and services for the users of the IoT architecture 100. For example, the application layer 130 may deliver and present the results of the processing of the sensor data to user devices 132 (e.g., mobile devices, such as a smartphone, a tablet, a laptop, and the like). As another example, the application layer 130 may instruct an operation of a connected device based on the sensor data, for example turning on or off a certain device, causing the device to transmit an alert to a user, triggering a certain action by the device, and the like.

In a four-layer architecture a data processing layer may be interposed between the network layer 120 and the application layer 130. The data processing layer may receive the sensor data via the network layer 120, may carry out processing of the sensor data, and may deliver the result of the processing to the application layer 130. The application layer 130 may then carry out user-related tasks based on the processing results obtained from the data processing layer. The data processing layer may thus provide analysis of the sensor data to deliver information to the users of the IoT architecture. The data processing layer may be capable of complex processing functionalities, e.g., making use of machine learning, AI, big data processing, and the like. In some aspects, the data processing layer may store previous sensor data, e.g., in one or more databases, to enhance the analysis and predictions carried out on new sensor data. Considering the data compression proposed herein in combination with the network architecture, the data compression may be carried out in any suitable layer of the network above the physical layer 110.

In general, the participants in an IoT architecture 100 (e.g., the sensor devices 102, the network layer 120, the data processing layer, the application layer 130, the business layer, etc.) may be configured for wire-based and/or wireless-based communication. A network participant may thus be configured to implement one of wire-based and/or wireless-based communication, or may be configured to implement both types of communication. Any suitable wire-based and/or wireless-based communication protocol may be used to regulate the exchange of data among network participants.

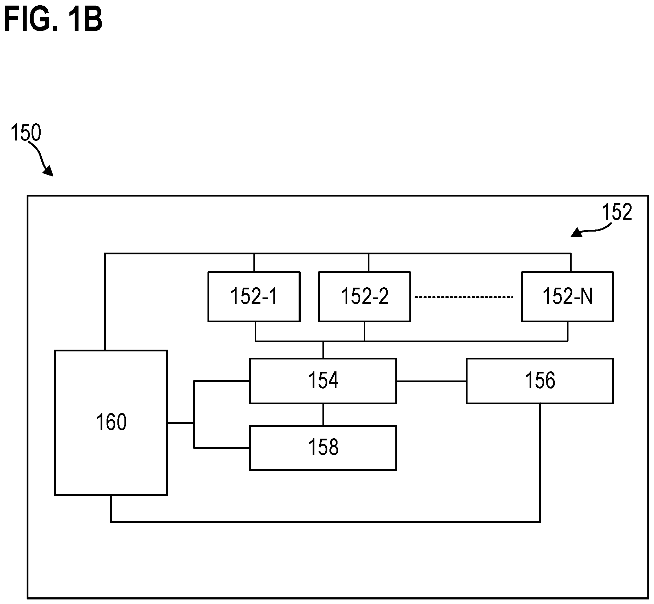

**FIG.1B** shows a sensor box 150 including a plurality of sensors 152 in a schematic representation, according to various aspects. A sensor box 150 may be an example of sensor device 102 for use in an IoT architecture, e.g., in the IoT architecture 100 or in any other suitable IoT architecture. A sensor box may represent the most relevant use case of the data compression strategy proposed herein, to enable an efficient transmission of the data collected by the plurality of sensors 152. It is however understood that the data compression strategy may be carried out also in other types of contexts, systems, or devices. It is also understood that the configuration illustrated in FIG.1B is exemplary, and a sensor box 150 may include additional, fewer, or alternative components with respect to those shown.

A sensor box 150 may include a chassis within which the various components of the sensor box 150 are disposed. The chassis may enclose the sensors 152 and the further circuits of the sensor box 150, such as a processing circuit 154, a memory 156, a communication circuit 158, a battery circuit 160, etc., discussed in further detail below. In some aspects, the various components of the sensor box 150 may be mechanically coupled to the chassis, to provide stability and robustness to the arrangement. In some aspects, the various components of the sensor box 150 may be electrically connected to one another via a circuit substrate, e.g., via a printed circuit board (PCB) to which the various components are connected or integrated and which defines electrical routing among the various components. The various components may be electrically and/or communicatively connected to one another. For example, the various components of the sensor box 150 may be connected to a communication bus over which data may be transferred among the components of the sensor box 150.

By way of illustration, a sensor box 150 (e.g., an IoT sensor box) may be a device that includes one or more sensors (N sensors) referred as $D_1,...,D_i,...D_N$ (with $i \in \{1, ..., N\}$, $N >= 1$), components for data processing and computing (e.g., a micro-controller), wireless or wired interface (as communication circuit 158), and a power supply or a rechargeable battery (as part of the battery source 160).

In some aspects, the sensor box 150 may be configured to participate in an Internet of Things network, e.g., the sensor box 150 may be configured as an IoT sensor box for an IoT architecture (e.g., the IoT architecture 100). In this scenario, the sensor box 150 may be configured to communicate with other network participants, e.g., with a network layer of the IoT architecture, e.g., with a cloud of the network. The sensor box 150 may further be configured to receive instructions from the network layer, e.g., instructions that prompt a certain action or response from the sensor box 150, such as carrying out a certain measurement, transmitting sensor data, and the like. The sensor box 150 may be configured to communicate with the other network participants via any suitable type of network or according to any suitable wire-based or wireless communication protocol.

As mentioned, the sensor box 150 may include one or more sensors 152, e.g., a plurality of sensors 152, e.g., a first sensor 152-1, a second sensor 152-2, ..., a n-th sensor 152-N. In general, the sensor box 150 may include any suitable number of sensors 152, e.g., one, two, three, four, five, ten, or more than ten. It is also understood that in principle the data compression described herein may be applicable also to a scenario in which a single sensor 152 is involved, so that the aspects discussed in relation to a sensor box 150 including multiple sensors 152 may apply in a corresponding manner to a sensor box or sensor device that includes a single sensor 152, and vice versa.

The sensors 152 may be of any suitable sensor type, depending on the physical quantities of interest to be sensed or monitored via the sensor box 150. Only as an example, the sensors 152 may include one or more of: a temperature sensor, a humidity sensor, a pressure sensor, a proximity sensor, a vibration sensor, a light sensor, an air quality sensor, a noise sensor, a concentration sensor, an accelerometer, a gyroscope, a gas sensor, an infrared sensor, an optical sensor, or any combination thereof. It is however understood that the data compression strategy described herein is generally applicable to any type of sensor and any type of sensor data. As a further example, considering an image sensor including a plurality of pixels, each pixel may be considered as an individual sensor delivering sensor data that may be processed according to the compression approach described herein.

A sensor 152 may be configured to sense a physical quantity and generate corresponding sensor data. The sensor data may be representative of a sensing value associated with the physical quantity. A sensing value may also be referred to herein as sensor reading value, measurement value, data value or data point. In general, the configuration of a sensor 152 may be adapted depending on the type of sensing process to be carried out. For example, for temperature sensing a sensor 152 may be configured to sense a temperature of the surrounding environment, e.g., the sensor 152 may include a thermistor or any other suitable component with a temperature-dependent behavior. As another example, for humidity sensing a sensor 152 may be configured to sense an amount of water vapor in the environment, e.g., the sensor 152 may include electrodes and the resistance between the electrodes may be indicative of the humidity. As a further example, for pressure sensing a sensor 152 may be configured to sense a (barometric) pressure of the environment, e.g., the sensor 152 may include a piezoresistive element or a capacitive element, etc. Further examples of sensors 152 may include a photodiode, an array of photodiodes, a membrane, etc.

The sensors 152 may include sensors of the same type and/or of different types. For example, the first sensors 152-1 may be of a first sensor type configured to sense a first physical quantity, the second sensors 152-2 may be of a second sensor type configured to sense a second physical quantity, ..., and the n-th sensors 152-N may be of a n-th sensor type configured to sense a n-th physical quantity. In some aspects, at least two sensor devices 152 may be of different sensor types, e.g., the first sensor type may be different from the second sensor type and the first physical quantity may be different from the second physical quantity, additionally or alternatively the n-th sensor type may be different from the first sensor type and from the second sensor type, etc. For example, the first sensors 152-1 may be a temperature sensor and the second sensor sensors 152-2 may be a pressure sensor, just as an example.

In some aspects, at least two sensors 152 may be of the same sensor type, e.g., the first sensor type may be the same as the second sensor type to sense the same physical quantity, additionally or alternatively the n-th sensor type may be the same as the first sensor type and second sensor type, etc. For example, the first a sensor 152-1 and the second a sensor 152-2 may be sensors of the same type assigned to monitoring different areas of the environment. Only as an example, the first a sensor 152-1 and the second a sensor 152-2 may be two microphones, e.g., oriented towards different directions. In some aspects, the sensors 152 may include a subset of sensors that share the same sensor type, and may further include one or more further sensors of one or more different sensor types.

The internal data transfer among the components of the sensor box 150 (e.g., between a sensor 152 and the processing circuit 154, between the processing circuit 154 and the memory 156, etc.) may be carried out according to any suitable communication protocol. In a preferred configuration, the sensors 152 and the processing circuit 154 may be coupled to one another via a wired connection and may be configured to communicate with one another according to a wired communication protocol, such as the Inter-Integrated Circuit bus ($I^2C$) protocol, the Serial Peripheral Interface (SPI) protocol, the single-wire (1-wire, or one-wire) protocol, the Controller Area Network (CAN) protocol, the Ethernet protocol, and/or the microwire protocol, as examples.

It is however understood that in principle the sensors 152 (or at least one or more of the sensors 152) and the processing circuit 154 may be coupled to one another via a wireless connection and may be configured to communicate with one another according to a wireless communication protocol, such as WiFi, Bluetooth, RFID, Near-Field Communication (NFC), Zigbee, and the like.

The processing circuit 154 may include any suitable type of software-based or hardware-based processing device, such as a microprocessor, a graphics processor, a central processing unit (CPU), a digital signal processor (DSP), a single core processor, a multi-core processor, a microcontroller, or any combination thereof. The processing circuit 154 may be configured to perform certain functionalities in accordance with instructions stored in the memory 156. The memory 156 may store instructions, e.g., in form of software, code, firmware, etc., that the processing circuit 154 executes to perform various functionalities. The memory 156 may include any number or combination of random-access memories, read only memories, flash memories, disk drives, optical storage, solid state storage, and the like.

In general, the processing circuit 154 may be configured to control (e.g., instruct) an operation of the sensors 152, and may be configured to receive sensor data from the sensors 152. For example, the processing circuitry 154 may be configured to instruct a sensor 152 to carry out the corresponding sensing measurement, or to transmit the results of the sensing measurement, or to enter a certain state (e.g., standby, idle, sleep, active, etc.), and the like. The processing circuit 154 may be further configured to receive the sensor data, process the sensor data, and transmit the (processed) sensor data to an end destination (e.g., to a network layer of an IoT architecture). Illustratively, each sensor 152 may be configured to generate respective sensor data (e.g., a respective stream of sensor reading values) and deliver the sensor data to the processing circuit 154 for further processing.

In general, the processing circuit 154 may be configured to process the sensor data generated by the sensors 152, e.g., to enable a transmission of the result of the sensing process. For example, a sensor 152 may be configured to generate an analog signal representative of the sensed physical quantity, and the processing circuit 154 may be configured to convert the analog signal into a digital signal representing the sensor data. As a further example, each sensor reading value from a sensor 152 may correspond to a respective time point, and the processing circuit 154 may be configured to group together the sensor reading values collected over a period of time to define a time series of sensor reading values (as sensor data). In the present disclosure, a time series of sensor reading values may be referred to as "stream" of sensor reading values. Illustratively, each sensor reading value (each data point) may correspond to the measurement of the physical quantity at a respective time point, and the individual values may define together time series of data points including a plurality of time points.

In some aspects, the processing circuit 154 may be configured to cause or instruct a storing of the information represented by the (digital) sensing signal(s) into the memory 156, e.g., for a later readout. The memory 156 may for example include a buffer or register that stores information representative of the individual sensor reading values prior to aggregation into a time series for defining the stream of sensor reading values. As another example, the memory 156 may store the combined sensor reading values as streams of sensor reading values.

The communication circuit 158 may be configured to enable a communicative coupling of the sensor box 150 with further entities (e.g., devices and systems) external to the sensor box 150, e.g., with other connected devices in an IoT network, or with a network layer of the IoT network, as examples. Illustratively, the communication circuit 158 may be configured to enable a communication from and towards the outside of the sensor box 150. The communication circuit 158 may thus provide a communication interface, and may include transmitter circuitry, receiver circuitry, and/or transceiver circuitry to transmit and/or receive information to/from the outside of the sensor box 150.

The communication circuit 158 may thus include any suitable component to enable the sensor box 150 to transmit/receive data (generally data transmitting signals). The communication circuit 158 may thus include one or more components that enable encoding/decoding of signals for transmission/reception over a physical medium. In general, the communication to/from the sensor box 150 may be implemented in the context of wired communication and/or wireless communication, so that the components of the communication circuit 158 may be selected according to the type of communication, e.g., to transmit/receive electrical signals using a wire, optical signals using an optical fiber, wireless signals over the air, etc.

In the following, particular reference is made to wireless communication to/from the sensor box 150, as it may be the most common scenario in the IoT context. Therefore, some terms may refer to the wireless context, e.g., to certain wireless technologies (such as WiFi, Bluetooth, etc.). However, it will be understood that the aspects and terms described with respect to wireless communications may apply in a corresponding manner to wired communication and vice versa.

For example, the communication circuit 158 may include a transceiver circuit configured to transmit/receive data according to a wired or wireless communication standard. In an exemplary configuration for wireless communication, the communication circuit 158 may include an antenna or may be coupled to an antenna, such as a single antenna or an antenna array, and may transmit and/or receive radio frequency signals using the corresponding antenna. In this configuration, a transceiver circuit may be an RF transceiver. As an example, the communication circuit 158 may include one or more amplifiers (e.g., power amplifiers, low-noise amplifiers) to amplify a received signal or a signal to be transmitted. As another example, the communication circuit 158 may include one or more frequency converters, e.g., to down-convert the frequency of a received signal or to up-convert the frequency of a signal to be transmitted. As another example, the communication circuit 158 may include one or more filters and mixers to select a desired frequency or frequency range for transmitting/receiving radio signals.

In some aspects, additionally or alternatively to the circuitry for wireless communication, the communication circuit 158 may be configured to enable wire-based communication. For example, the communication circuit 158 may include one or more switches and one or more resistive elements to control a voltage level or current level at an electrically conductive connection between the sensor box 150 and the entity to which the data should be transmitted (and/or from which data should be received). The control of the voltage level or current level may define a modulation that represents or encodes information in the output signal. For example, a first voltage level at the wired connection (e.g., a high voltage level) may be associated with a logic "1", and a second voltage level at the wired connection (e.g., a low voltage level) may be associated with a logic "0". It is however understood that the definition of logic "1" and logic "0" and of the type of signal modulation associated thereto may be arbitrary.

The battery circuit 160 may be configured to deliver power to the various components of the sensor box 150. In some aspects, a sensor device 152 may have an internal energy source (e.g., an internal battery), and may be decoupled from the battery circuit 160 of the sensor box 150. In other aspects, a sensor device 152 may be free of an internal energy source and may receive power from the battery circuit 160 of the sensor box 150. As an exemplary realization, the battery circuit 160 may include a battery or a plurality of batteries, and may further include a battery management circuit configured to control the delivery of power from the battery or batteries. In other aspects the sensor box 150 may include, additionally or alternatively to the battery circuit 160, a supply terminal configured to allow a connection of the sensor box 150 with a power supply external to the sensor box 150 (e.g., with a power grid).

In the IoT context, large amounts of sensor data may be transmitted from the perception layer 110 to the network layer 120, e.g., from a sensor box 150 to a gateway of the network layer 120. For example, considering a sensor box 150 including a plurality of sensors 152, the transmission of such large amounts of sensor data may become a challenging task, in particular considering the usually limited power available at the sensor box 150.

The present disclosure is directed to a hardware-independent data compression strategy that enables high compression rates and may be implemented in a time- and energy-efficient manner. The data compression discussed herein facilitates the transfer of large amounts of sensor data, e.g., from a sensor box towards an end destination for further processing.

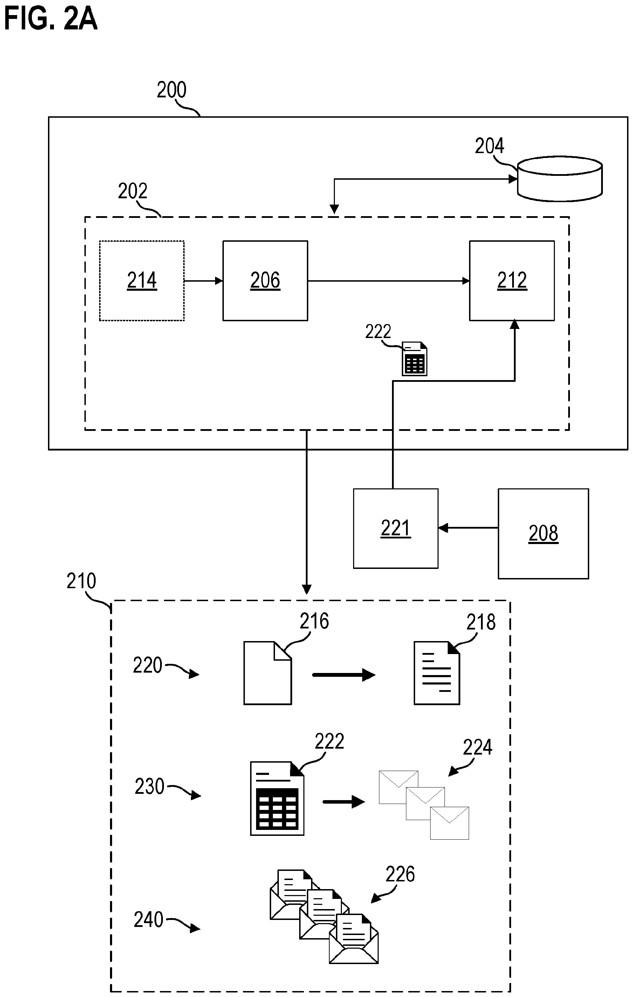

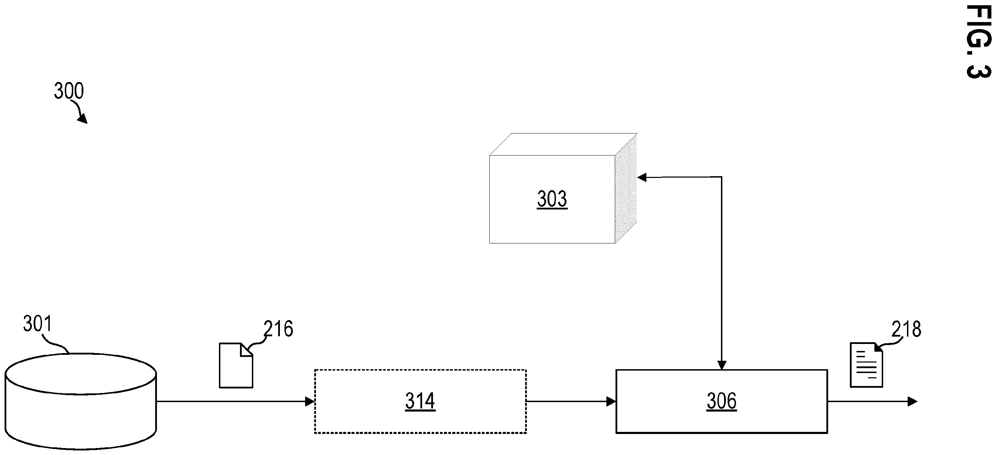

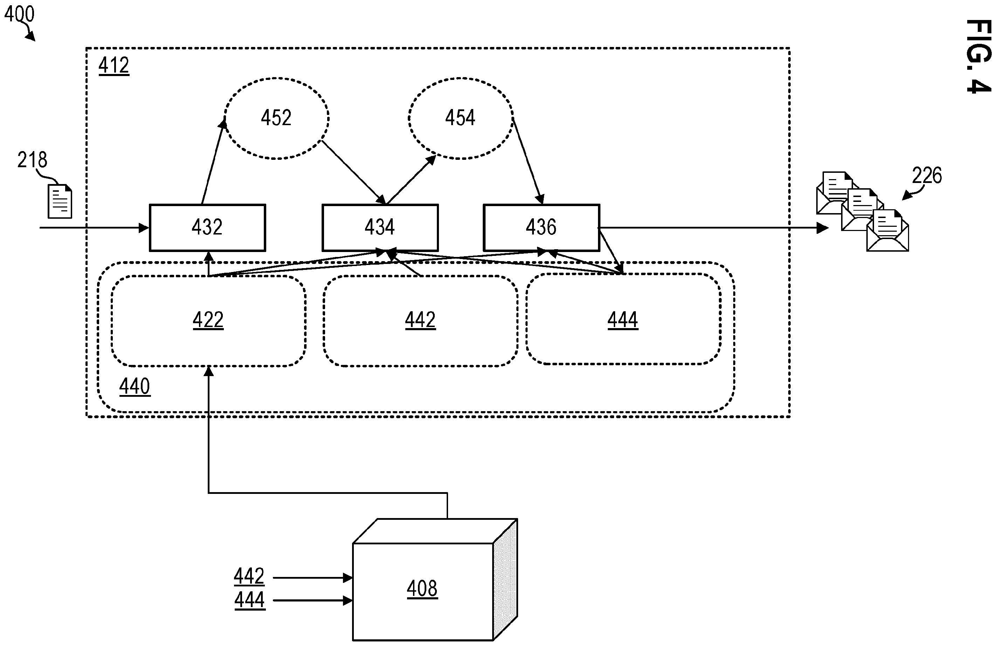

The general aspects of the proposed data compression will be discussed in relation to FIG.2A to FIG.2C. Further aspects related to specific parts of the data compression will be discussed in relation to FIG.3 and FIG.4.

**FIG.2A** shows a data compression circuit 200 in a schematic view according to various aspects. The data compression circuit 200 may include a processing circuit 202 and a memory 204 coupled to the processing circuit 202. The memory 204 may be arranged to store instructions (e.g., software instructions) executed by the processing circuit 202. The instructions may cause the processing circuit 202 to perform an adapted method of lossless compression of sensor data 210, which is described in further detail below. Aspects described with respect to a configuration of the processing circuit 202 may also apply to the method 210 and vice versa. A data compression circuit may also be referred to as circuit for lossless compression of sensor data, or simply as sensor data compressor.

In general, the data compression circuit 200 may be a dedicated device in an architecture that includes one or more sensors, e.g., in the IoT network 100. Considering that data compression facilitates the transmission of the sensor data, it is beneficial to carry out the compression process close to the source of the sensor data. In a preferred configuration, the data compression circuit 200 may thus be part of a sensor device or sensor box (e.g., the sensor box 150). Illustratively, the data compression circuit 200 may be a dedicated circuit in the sensor device or sensor box for compressing the sensor data prior to transmission (e.g., towards the network layer of the IoT architecture), or the functionalities of the data compression circuit 200 may be implemented by a processing circuit of the sensor device or sensor box (e.g., the processing circuit 154).

It is however understood that, in principle, the data compression may be carried out elsewhere within the system (outside of a sensor device or sensor box delivering the sensor data), e.g., in a data acquisition circuit of an IoT architecture, in a gateway of the IoT architecture, in the network layer for subsequent transmission to the processing layer or application layer, or at any other suitable location. The functionalities of the data compression circuit 200 and corresponding method 210 may thus be implemented by any one of the devices, layers, and circuits involved in the system including one or more sensors. As mentioned above, the data compression circuit 200 and corresponding method 210 may also be for use in contexts other than an IoT architecture, and may in general be applied in any suitable context where the compression of sensor data may be beneficial.

The data compression may be carried out on sensor data originating from one or more sensors (e.g., from a plurality of sensors, e.g., the plurality of sensors 152 of sensor box 150). In a preferred configuration, the data compression may be carried out on a plurality of sensor data coming from a plurality of sensors, as this may allow a more efficient process by inserting sensor reading values from multiple sensors into the same data packet, thus reducing the influence of the size header information of the packet on the data transmission. However, the data compression proposed herein may in principle be carried out in case of a single sensor providing sensor data (illustratively, a single stream of sensor data).

The data compression may include several steps. Accordingly, the data compression circuit 200 may be logically divided into a plurality of components, namely a sequencer 206 (also referred to as sequencing circuit), a profiler 208 (also referred to as profiling circuit), and a compressor 212 (also referred to as compression circuit). Optionally the data compression circuit 200 may further include a noise reduction circuit 214. It is understood that the functionalities associated with the data compression may be carried out by individual components (e.g., individual, dedicated portion of the circuit 200), or may be carried out by a plurality of components acting together. Stated in a different fashion, the sequencer 206, profiler 208, compressor 212, and noise reduction circuit 214 may be realized as separate circuits configured to implement a respective function, or as a single circuit configured to implement more than one function. It is also understood that, in principle, the data compression may be carried out by a plurality of circuits that are physically separated from one another and are communicatively coupled with one another (e.g., via a wired or wireless connection). For example, a first circuit may implement the sequencer functionality and transmit the result to a second circuit that implements the profiler functionality, etc. The term "noise cancellation" may be used herein in the same manner as "noise reduction". The profiler may be also referred to herein as "profile oracle".

In general, the data compression circuit 200 may be configured, according to the method 210, to carry out a lossless compression of sensor data generated by a corresponding sensor. In some aspects, the data compression circuit 200 may be configured, according to the method 210, to carry out a lossless compression of a plurality of sensor data (streams) generated by a corresponding plurality of sensors. Considering a plurality of sensors, the sensors may be of the same sensor type or of different sensor types, as discussed in relation to FIG. 1A and FIG.1B.

According to various aspects the sequencer 206 may be configured to receive sensor data 216. The sensor data 216 may be associated with a corresponding sensor (e.g., one of the sensors 152 of the sensor box 150). Illustratively, the sensor data 216 may include a plurality of sensor reading values representative of the result of a sensing process carried out by the sensor. For example, the sequencer 206 may receive the sensor data 216 directly from the sensor that generated the sensor data 216 (e.g., as raw sensor data output from the sensor). As another example, the sequencer 206 may receive the sensor data 216 after the sensor data underwent one or more pre-processing steps (e.g., fusion, noise reduction, and the like).

In some aspects, the sensor data 216 may include an aggregation of sensor data from multiple sensors, e.g., the sensor data 216 may be obtained via a sensor fusion process. In this scenario, the sensor reading data 216 may be associated with more than one sensor, and the sensor reading values may be representative of the fusion of the results of a plurality of sensing processes by the plurality of sensors. As another example, the sensor data 216 may include derived data (e.g., derived values) determined based on the result of the sensing process. Illustratively, in this scenario the sensor reading values may be derived values obtained from the actual sensing process by the sensor (or sensors in case of sensor fusion). As a further example, the sensor data 216 may include "meta" data related to the sensor(s), e.g., calibration data representative of a calibration level of the sensor(s). In general, the sequencer 206 may receive the sensor data 216 from a data source, and the data source may be the sensor itself, or a further entity that pre-processed the data (e.g., to derive new values, to provide sensor fusion, and the like).

According to various aspects, the plurality of sensor reading values may define a time series of values (illustratively, a time series of data points, each associated to a corresponding time point). Illustratively, the sensor data 216 may include an ordered sequence of sensor reading values, each corresponding to a respective time point. Stated differently, the sensor data 216 may be representative of the result of a sensing process carried out over a time period, and each sensor reading value may be representative of the instantaneous result at a respective time point during the time period. In this regard, the sensor data 216 may be a stream of sensor reading values (illustratively, a time series or sequence of sensor reading values).

As mentioned, the data compression may be carried out on data from a plurality of sensors. In this scenario, the sequencer 206 may receive a plurality of sensor data, each associated with a corresponding sensor of a plurality of sensors. Illustratively, the sequencer 206 may receive a plurality of sensor data, each including a plurality of respective sensor reading values representative of the result of a sensing process by the corresponding sensor. The sequencer 206 (and, more in general, the data compression circuit 200) may process the plurality of sensor data from the plurality of sensors at the same time.

In case of a plurality of sensor data, the sequencer 206 may include a corresponding plurality of sequencers, each configured to carry out the sequencing of the sensor data from one of the plurality of sensors. Illustratively, in this scenario there may be a unique sequencer for each sensor of the plurality of sensors, and that sequencer may receive/process the sensor data associated with the respective sensor. Even in case of a plurality of sensors (and corresponding plurality of sequencers), the data compression approach may still make use of a single compressor 212 that receives the plurality of outputs from the plurality of sequencers.

The sequencer 206 may be configured to convert a format for representing the sensor reading values from a first format defined by the sensor into a second format. Illustratively, the sequencer 206 may act on the sequence of sensor reading values to convert their representation from a first (raw) representation as output from the sensor, into a second representation. The conversion of the format in which the data are represented may facilitate the subsequent data compression by using a (second) format to represent the data that may be more suitable than the original/raw format for carrying out the data compression.

In general, the second format may be a format that the compressor 212 expects the sensor data to be compressed to have. Illustratively, the second format may be a data format supported by the compressor 212 (and with the compression profiles), such that the compressor 212 may operate more efficiently on data represented according to the second format than on data represented according to another format (e.g., the first format). Stated differently, the compressor 212 may have been pre-programmed or pre-trained to operate on data having the second format, such that when the compressor 212 receives data having such format it may carry out a data compression that achieves higher compression gains (compared to a data compression on another format).

The second format may thus be any suitable arbitrary format to represent the data, under the assumption that the compressor 212 has previous knowledge of such format. The second format may thus be understood as a known data format for the compressor 212, e.g., a data format for which the compressor 212 has previous knowledge on how to compress data having such format. Stated differently, the second format may be a standardized and pre-established format for the data to be compressed by the compressor 212. In absence of the format conversion, the compressor 212 could still be able to carry out data compression, but at a lower level of efficiency (e.g., with lower compression gain). The second format may thus generally allow the compressor 212 to obtain higher compression gain compared to the first format.

By way of illustration, the second format may define an ideal representation for compression that may maximize compression gains. In general, the conversion into the second format may thus enable a more efficient data compression of the sensor reading values with respect to the first (raw) format. As an example, a sensor reading value may include a number (e.g., a floating point, an integer, and the like), and the second format may define a representation of the number that facilitates the compression of the sensor data. For example, a sensor reading value in the first format may include a first number of digits, and the sensor reading value in the second format may include a second number of digits. The second number of digits may be less than the first number of digits. As another example, the second number of digits may be a predefined number of digits, whereas the first number of digits may vary from sensing to sensing.

In some aspects, the sequencer 206 may be configured to convert the format for representing the sensor reading values into the second format according to a compression characteristic of the sensor reading values. Illustratively, the sequencer 206 may identify a suitable second format based on properties of the sensor reading values that influence the compression. For example, for a time series of values a certain type of second format may be suitable, for a dictionary of values another type of second format may be suitable, etc. The sequencer 206 may thus provide the sequencer reading values 218 in the (second) format that supports a compression with higher gain for the sensor reading values 216.

As an example, the sequencer 206 may be configured to use a second format that fulfills a compression criterion (and discard other second formats that do not fulfill the criterion). Any suitable compression criterion may be defined. For example, the compression criterion may include an expected compression gain for the compression of the sensor reading values 218 when represented with that second format (e.g., the fulfillment of the criterion may be the gain being higher than a reference threshold). As another example, the compression criterion may include an expected compression speed for the compression of the sensor reading values 218 when represented with that second format (e.g., the fulfillment of the criterion may be the duration of the compression being less than a reference threshold).

In general, the second format may be different from the first (raw) format. However, in some scenarios, the first (raw) format may already be the most suitable format for the data compression. In this case, the sequencer 206 may carry out an identity transformation to obtain data represented in the second format (which in this case would correspond to the first format). An example may be a fixed-length non-negative integer measurement index which increases by 1 for each transmission.

In some aspects, the sequencer 206 may thus be configured to convert the representation of the sensor reading values into a second format that enables representing the sensor reading values in a predetermined and standardized manner, e.g. using a predefined number of bits. For example, considering the case in which the initial sensor reading values include a floating-point representation, the number of bits that may be required to represent floating point numbers may vary greatly depending on the values to be represented. The conversion into a second format for representing the sensor reading values may instead ensure that the (converted) values may be represented using a predefined (e.g., fixed) number of bits. In some aspects, the operation of the sequencer 206 may be understood as converting the representation of the sensor reading values into a second format that allows representing all the values (e.g., all the numbers) with the minimum possible number of bits (or Bytes).

The second format may thus be more beneficial for the compression with respect to the original format of the sensor data 216. In addition, the conversion into the second format has the benefit of making the compression platform-independent. Illustratively, the raw data may have a format that is specific to the sensor (e.g., to the sensor's register layout, the architecture of the MCU, and the like). On the other hand, the second format may be hardware-independent (i.e., sensor-independent), thus facilitating the operation of the compressor 212. The second format may thus be a sensor-independent format for representing sensor data.

By way of illustration, the sequencer 206 may be configured to sequence the sensor reading values to convey the information represented by the sensor reading values using a representation other than the original (first) format of the sensor reading values (if appropriate). The sequenced sensor reading values 218 may thus convey or represent the same information about the sensed physical quantity as the initial sensor data 216 (and non-sequenced sensor reading values) in a format that allows expressing the information in a way that facilitates the operation of the compressor 212.

The introduction of a sequencing step in the data compression may be based on the realization that it may be beneficial for the compression to act on data that have a more standardized format (e.g., a predefined fixed length), rather than data whose format (e.g., size or length) may vary greatly from one sensing process to another. For example, it may be beneficial for the compression to be carried out on data having a predefined number of bits (or Bytes), and the sequencing may "force" the sensor data 216 into a representation having the minimum bit length or minimum byte length that still allows representing all the sensor reading values.

Considering the scenario with a plurality of sensor data from a plurality of sensors, each sequencer may be configured to convert the representation of the respective sensor reading values from the first format defined by the respective sensor into a respective second format (illustratively, the most suitable second format for the specific sensor reading values from that sensor). The "second" format may be different for different sensors, as the way the data are converted may be dependent on the type of data (e.g., integer, floating point, positive numbers, negative numbers, and the like).

The sequencer 206 may deliver, as output, the sensor reading values as sequenced sensor reading values 218 (sequenced sensor data) represented with the second format. Illustratively, the output of the sequencing process carried out at the sequencer 206 may be a series of sensor reading values 218 that are no longer in the initial (raw) format but are represented using the representation of the second format. The sequencer 206 may deliver the sequenced sensor reading values 218 to the compressor 212.

According to various aspects, the compressor 212 may be configured to select a compression profile 222 for carrying out a lossless compression of the sequenced sensor reading values 218. In this regard, the data compression circuit 200 may be coupled with a profiler 208 configured to define (e.g., compute, calculate,) a plurality of possible compression profiles 221 to be used by the compressor 212 for the (subsequent) compression of the sequenced sensor reading values 218.

The operation of the profiler 208 will be described in further detail below. In brief, the profiler 208 may be configured to determine a plurality of compression profiles 221 to be used for compressing the sensor data 216, and the compression profiles 221 may be available to the compressor 212 (and to a decompressor, described below). In some aspects, the profiling may happen "off-line", or in general prior to carrying out the data compression. In other aspects, in addition to the "off-line" profiling, the profiler 208 may be configured to create new compression profiles 221 or adapt existing compression profiles 221 during the compression process.

To carry out the compression of the sequenced reading values 218, the compressor 212 may then select one of the plurality of predetermined compression profiles 221 for carrying out the data compression in the current scenario. There may be various ways for the profiler 208 to determine the compression profiles, as will be discussed in further detail in relation to FIG.4. In some aspects, the profiler 208 may include a profile oracle configured to determine the compression profiles, e.g., using a machine learning approach (see also FIG.4).

In general, the compressor 212 may be configured to select the compression profile 222 based on the sequenced sensor reading values 218, e.g., taking into account a behavior over time of the sensor data. Illustratively, the compressor 212 may identify the compression profile 222 that is suitable for lossless compression taking into consideration the temporal evolution of the sequenced sensor reading values 218. This approach may be based on the realization that sensor data (e.g., a time series of data points) may have a behavior that is not constant over time, depending on the measured quantity. For example, in a certain time period the measured quantity may remain substantially constant, so that consecutive sensor reading values may be equal to one another or may vary by a relatively small amount. In another time period the measured quantity may have greater fluctuations, so that consecutive sensor reading values may have relatively greater variations from one another, etc.

In this context, the second format into which the sequencer 206 converts the sensor reading values may allow the compressor 212 to represent the temporal evolution of the sensor data 216 with a more compact representation (e.g., fewer bits) compared to the raw format of the sensor data 216. For example, the second format may allow the compressor 212 to represent the temporal evolution of the sensor data 216 in terms of a difference between consecutive sequenced sensor reading values, which may allow a compressed representation compared to the actual (initial) sensor reading values.

The compression profile 222 may include (e.g., define, list, contain) a plurality of compressed data formats 224, each defining a respective size of a data slot of a (compressed) data packet for transmitting the sequenced sensor reading values 218. Illustratively, a compressed data format 224 may represent a corresponding format for a data packet having a respective length (in bits) of a data slot for transmitting data/information associated with the currently processed sensor data using the data packet.

A "compressed data format" may thus represent a respective size to be used for including (compressed) data in a data packet that has a data slot of the size indicated by the compressed data format. A "compressed data format" may also be referred to herein as "compressed packet type".

In view of the considerations above regarding the behavior over time of sensor data, the size of the information to be transmitted may vary over time. For example, at the beginning of the sensing period, or in case of great fluctuations of the measured quantity, there may be the need for data packets having a larger/longer data slot to allow transmitting more information, e.g., the instantaneous values of the sensed quantity during such periods. Additionally, larger packets may be used to keep the compressor 212 and decompressor in synchronization when the communication channel is imperfect (e.g., a transmission of uncompressed representation (identity transformed packet) may be used to reset the decompressor context). On the other hand, in case of no fluctuations or small fluctuations of the measured quantity, data packets having a smaller/shorter data slot may be sufficient to convey the necessary information. For example, if the sensed quantity remains constant, it may suffice to transmit a data packet with an empty data slot, relying on the previously transmitted (sequenced) sensor reading value. As another example, in case of small fluctuations, it may suffice to transmit a data packet with a relatively small data slot containing an indication of the difference (in other words, the delta) with respect to the previous sensor reading value, or containing only the portion that varies (e.g., only the bits that vary) between the consecutive sensor reading values, etc.

As mentioned above, a data packet may generally include a plurality of fields or portions. A compressed data packet may include, for example, a header field containing metadata and information for identifying the packet, for identifying the sender, for identifying the destination, etc. For example, the header field may include information representative of a context identifier that indicates the origin of the data (e.g., from which compressor the packet is coming from). Additionally or alternatively the header field may include information representative of a sequence number that identifies a position of the data packet in the sequence to enable the reconstruction of the data at the receiver side. Additionally or alternatively the header field may include information representative of the type of packet, and the like.

Only as a numerical example, the header field may have a length of 1 Byte.

In general, the metadata from the compression may be included anywhere inside a compressed data packet, even in the middle, as long as the decompressor is in condition of deducing the location of the metadata. For example, considering that each compressed data format defines a different size, then the format of the packet may be deduced from the size of the packet itself (without the need to explicitly indicate the packet type or data format in the metadata). In this case, the decompressor may identifiy the location of the metadata based on the packet's structure. Additionally some of these meta fields may be deduced, as in the case of the packet type or data format. As another example, considering that in general there is only one compressor per decompressorr, also the context id may be deduced. This in turn can be used to reduce the compressed packet size further.

The term "data slot" may be used herein to describe a portion of a compressed data packet dedicated to transporting compressed sensor data. In general, a compressed data packet may include a plurality of data slots, e.g., N data slots, e.g., one data slot for each sensor of interest in the system in which the data compression is carried out. Illustratively, a compressed data packet 224 may include a plurality of data slots (or a single slot in case of a single sensor), each data slot to be used for containing (compressed) sensor reading values from a corresponding sensor of a plurality of sensors. The compression profile 222 for compressing data from a single sensor may identify the suitable size of the data slot(s) for the sensor data from that sensor. Considering a scenario with a plurality of sensor data from multiple sensors, the compression profile 222 may identify the suitable sizes of the data slots for the sensor data from the plurality of sensors. For example, the plurality of data slots may be referred to as data field.

The compressor 212 may thus identify the behavior over time (illustratively, the fluctuations or variations over time) of the sequenced sensor reading values 218 to determine which compressed data formats 224 or which combination of compressed data formats 224 to use for transmitting the sequenced sensor reading values 218 (after compression). The compressor 212 may select the compression profile 222 that minimizes the overall size of the data packets (e.g., the combined size of the respective data slots) to be used for transmitting the sequenced (and then compressed) sensor reading values 218, while still allowing to convey the full information contained in the sequenced sensor reading values 218 (and in the sensor data 216).

The compression profile 222 may include any suitable number of compressed data formats 224, e.g., two, three, four, five, or more than five. The compression profile 222 may include a first compressed data format defining a first size of the data slot (or a first plurality of sizes for the plurality of data slots in case of multiple sensors), a second compressed data format defining a second size of the data slot (or a second plurality of sizes for the plurality of data slots), a third compressed data format defining a third size of the data slot (or a third plurality of sizes for the plurality of data slots), etc. Each size (or plurality of sizes) of the data slot may be unique among the plurality of compressed data format 224. It is understood that, in principle, the compression profile 222 may include a single compressed data format 224. This may be the case, for example, if the behavior of the sequenced sensor reading values 218 is such that requires the transmission of the full values of the time series.

The compressed data packet may thus include a data slot of variable size, depending on the parameters set by the profile. In general, the size of the data slot for the sensor readings from a certain sensor may be dependent on the relative difference between consecutive sequenced sensor reading values 218, which may influence how the behavior of the data may be represented. As numerical examples, a data slot of a compressed data packet may have a length in the range from 0 Bytes to 4 Bytes, e.g., a length in the range from 1 Byte to 2 Bytes. For example, in case of consecutive sequenced sensor reading values 218 that do not vary from one another, a compressed data packet with a 0 Byte data slot may be used (repeating the previous value upon decompression and reconstruction). In case of consecutive sequenced sensor reading values 218 with relatively small variations (e.g., variations that may be expressed with a relatively small number of bits, e.g., with 4 or less bits, e.g., with 2 or less bits), a compressed data packet with a 1 Byte data slot (e.g., 1-Byte Least Significant Bit, LSB) may be used. As a further example, in case of consecutive sequenced sensor reading values 218 with relatively large variations (e.g., variations that may only be expressed with a relatively large number of bits, e.g., with 8 bits or more), a compressed data packet with a 2 Byte data slot (2-Octets) may be used, etc. It is understood that the values mentioned herein are exemplary, and that the size of the data slot may be suitably adapted depending on the circumstances.

In some aspects, a compressed data packet 224 may further include a trailer field containing information that allows verifying an accuracy of the transmission of the compressed data packet. For example, the trailer field may include a cyclic redundancy check (CRC) or any other suitable type of error-detecting code that allows determining, at the receiver side, whether the data packet was corrupted during transmission. As mentioned above for the header information, also the "trailer information" may be transmitted at any suitable location within the compressed data packet, and/or may be deduced at the decompressor side based on the properties of the compressed data packet.

According to various aspects, the compressor 212 may be configured to carry out a lossless compression of the sequenced sensor reading values 218 using the compressed data formats 224 defined by the compression profile 222. Illustratively, the compressor 212 may be configured to carry out a lossless compression of the sequenced sensor reading values 218 using any suitable lossless compression algorithm to obtain compressed sensor reading values (e.g., Huffman coding, Run Length Encoding (RLE), Shannon-Fano compression algorithm, Lempel-Ziv-Welch (LZW) compression, and the like), and to prepare the compressed sensor reading values for transmission using the compressed data formats 224. The compressor 212 may thus be configured to provide compressed data packets 226 that contain the compressed sensor reading values according to the compression profile 222 defined by the profiler 208 (illustratively, according to the data formats 224 contained in the profile 222).

Stated differently, the compressor 212 may be configured to carry out a mapping of the sequenced sensor reading values 218 into a compressed representation to provide the compressed sensor data. The compressor 212 may thus "convert" the sequenced sensor reading values 218 from the representation provided by the second format into a compressed representation. The compressor 212 may adopt any suitable approach to carry out the mapping, e.g., based on any suitable algorithm.

The compressor 212 may select which compressed data packet 226 to use among the types available in the profile for preparing the compressed sensor reading values for transmission. Illustratively, the compressor 212 may match the size of the compressed sensor reading values from one sensor or multiple sensors to the size of the data slots of a compressed data format, and use a compressed data packet having that format if it is capable of containing the compressed sensor data to be transmitted.

As mentioned above, a compressed data packet 226 may include a plurality of data slots, each containing one compressed sensor reading value or a subset of compressed sensor reading values from a respective sensor, and the length of the data slot may be defined by the specific format of that data packet. Illustratively, considering compression of sensor data from multiple sensors at the same time, the compressor 212 may carry out N compressions, and pack the compressed sensor data from the plurality of sensors into the respective data slot of a compressed data packet 226. The compressed data packets 226 may include one or more compressed data packets having a first compressed data format with a first size of the data slot (or first plurality of sizes), one or more compressed data packets having a second compressed data format with a second size of the data slot (or second plurality of sizes), one or more compressed data packets having a third compressed data format with a third size of the data slot (or third plurality of sizes), etc., as defined by the profile 222. The compressor 212 may use each compressed data packet for transmission of a compressed sensor reading value or a subset of compressed sensor reading values that fit in the size of the data slot(s) for that data format (and accordingly for the compressed data packet configured according to that data format).

In case of sensor data 216 from a plurality of sensors, and a corresponding plurality of sequenced sensor reading values 218 each from a corresponding sensor, the compressor 212 may be configured to select a compression profile 222 for the combined transmission of the plurality of sequenced sensor reading values 218 (and then compressed sensor reading values). Illustratively, the compressor 212 may determine which compressed data formats 224 or which combination of compressed data formats 224 to use for transmitting the plurality of sequenced sensor reading values 218 (after compression). In this scenario, each compressed data packet 226 may contain data (e.g., respective compressed sensor reading values) from more than one sensor, as mentioned above. The compressor 212 may thus include in the data slots of the same compressed data packet 226 data from multiple sensors. In this case, the "weight" of the header field (and trailer field) of the compressed data packets on the transmission is reduced compared to the case with a single sensor, thus providing a resource-efficient data transmission in a multi-sensor scenario.

From the point of view of the method 210, the method 210 may include, in 220, receiving sensor data 216 including a plurality of sensor reading values and converting a format for representing the sensor reading values from a first format defined by the corresponding sensor into a second format, thereby providing the sensor reading values as sequenced sensor reading values 218 represented with the second format. The method 210 may further include, in 230, determining a compression profile 222 for carrying out a lossless compression of the sequenced sensor reading values 218. The compression profile 222 may include a plurality of compressed data formats 224, each defining a respective size of a data slot for transmitting one or more of the sequenced sensor reading values 218. The method 210 may further include, in 240, carrying out a lossless compression of the sequenced sensor reading values 218 to obtain compressed sensor reading values, wherein the second format is supported by the lossless compression; and preparing the compressed sensor reading values for transmission using the compressed data formats 224 defined by the compression profile. Illustratively, the method 210 may include preparing a plurality of compressed data packets 226 for transmission, each including one or more of the compressed sensor reading values, according to the compression profile 222.

The proposed approach may thus be based on a compressor 212 that takes a profile that is specific to the application/sensors, as well as uncompressed data that has been sequenced as input. This provides a boundless flexibility that may be deployed in a sensor box including any set of sensors. The proposed approach is thus different from conventional strategies, in which a compressor only takes the data to compress, without a smart selection of suitable data formats for the transmission of the data.

By way of illustration, the proposed data compression may include a combination of the sequencing to define the format of the sensor reading values, and a corresponding selection of the compressed data packets to be used for transmitting the data. The proposed approach may be understood, in some aspects, as a data exchange format that identifies the optimal format for transmitting sensor data in terms of size and reliability.

According to various aspects, the data compression may be carried out in real-time. Compared to conventional approaches that operate on batches of sensor data, the proposed approach allows a real-time sequencing and compression of the sensor data. Illustratively, the sequencer 206 may operate on the time series of sensor reading values on the fly to deliver the sequenced sensor reading values 218. In a corresponding manner, the compressor 212 may select the compression profile for the transmission of the sequenced sensor reading values 218 during a transmission instance, and the compressor 212 may prepare the compressed sensor reading values for transmission in the transmission instance according to the compression profile 222.

In this context, the term "real-time" may indicate that that the sequencer 206 carries out the sequencing of the time series of sensor reading values upon receiving each sensor reading value, without waiting for the reception of all the sensor reading values contained in the sensor data 216. Stated differently, the sequencer 206 may carry out the sequencing of each sensor reading value using the time required for the signal propagation and signal processing, without additional waiting time.

The term "transmission instance" may be used herein to describe a transmission of data carried out upon execution of the instructions or code that causes the data compression circuit 200 to execute the data compression described above. Illustratively, the data compression circuit 200 may take one or more clock cycles to execute the instructions that define the data compression (e.g., the various steps discussed above), and a "transmission instance" may describe the transmission of the compressed data packets 226 that are ready for transmission at the time of the execution of the corresponding instruction.

In this regard, the proposed approach allows sequencing and compressing sensor data originating from sensors having different sampling rates. Illustratively, in case of sensor data from a plurality of sensors it may be the case that different sensors (e.g., from the plurality of sensors 152) have different sampling rates, e.g., a first sensor may have a first sampling rate, a second sensor may have a second sampling rate (smaller or greater than the first sampling rate), etc. In a more common scenario, all the sensors may have the same or substantially the same sampling rate (e.g., sampling rates that differ by less than 5%, or less than 2%, or less than 1%).

In general, high-rate sensors provide measurements via a FIFO buffer, such that a measurement/sampling on the MCU actually receives, e.g., 100 raw values which are then averaged together. An example of this may be sensor fusion of IMU to get rotation as quaternion. In this case, the sensor fusion algorithm expects measurements at 100 Hz, but the sensor device transmits at 10 Hz. Thus, the sensor device in practice reads out the IMU FIFO buffer at 10 Hz, forwards all 100 readings from IMU FIFO buffer to the sensor fusion algorithm and then takes only the result from after the 100th entry.

In case of sensor data from sensors having different sampling rates, it may be the case that during a transmission instance one sensor generates and delivers the corresponding sensor data, whereas another sensor does not generate/deliver the corresponding sensor data during that transmission instance. The proposed approach may operate also in this situation, by sequencing and preparing for transmission the sensor data available during the transmission instance. Thus, each sensor or data source may have its own sampling rate, so that the sensors may or may not generate data readings for transmitting during the process of preparing compressed data.

As mentioned above, the data compression circuit 200 may optionally include a noise reduction circuit 214. The noise reduction circuit 214 may be configured to receive the sensor data (from one or more sensors), and carry out a noise reduction process on the sensor data before delivering a noise-reduced version of the sensor data to the sequencer 206. In this scenario, the sequencing and compression may be carried out on the noise-reduced data. The noise reduction may facilitate distinguishing the actual signal in the data. The amount of noise reduction that may be carried out on the sensor data from a certain sensor may be specified in the data sheet of the sensor. From the point of view of the method 210, the method 210 may optionally include carrying out a noise reduction (e.g., a filtering) of the sensor data prior to sequencing of the sensor data 216.

The noise reduction circuit 214 may reduce the noise in any suitable manner, as generally known in the art. For example, the noise reduction circuit 214 may be configured to filter the sensor data to reduce the noise present in the sensor data. The filtering may include any suitable type of filter, such as high-pass, media, average, truncation, low-pass, band-pass, as examples.

In some aspects, the data compression circuit 200 may optionally include a compensation for sensor drift. In this regard, sensor drift may describe a gradual change in a sensor's output over time, without a corresponding change of the measured quantity. For example, the sensor data from a sensor may be compensated for sensor drift, e.g., based on sensor data from other sensors (e.g., sensor data from auxiliary sensors of that sensor IC), prior to sequencing. For example, the data compression circuit 200 may include a dedicated drift compensation circuit, or the drift compensation functionality may be carried out by the noise reduction circuit 214.

In some aspects, the data compression circuit 200 may be further configured to cause a transmission of the compressed data packets 226 that contain the compressed sensor reading values (e.g., over a wired medium or wireless medium). For example, the data compression circuit 200 may include a communication circuit or may be communicatively coupled with a communication circuit (e.g., the communication circuit 158 of the sensor box 150), and may be configured to deliver the compressed data packets 226 to the communication circuit. The communication circuit may transmit the compressed data packets 226 to a further entity (an end-destination, e.g., at a network layer of an IoT architecture). The further entity may be a remote entity, e.g., the further entity may be disposed externally from a sensor box including the data compression circuit 200. From the point of view of the method 210, the method 210 may optionally further include instructing a transmission of the compressed data packets 226, e.g., the method 210 may include transmitting the compressed data packets 226 that contain the compressed sensor reading values (e.g., over a wired medium or wireless medium).

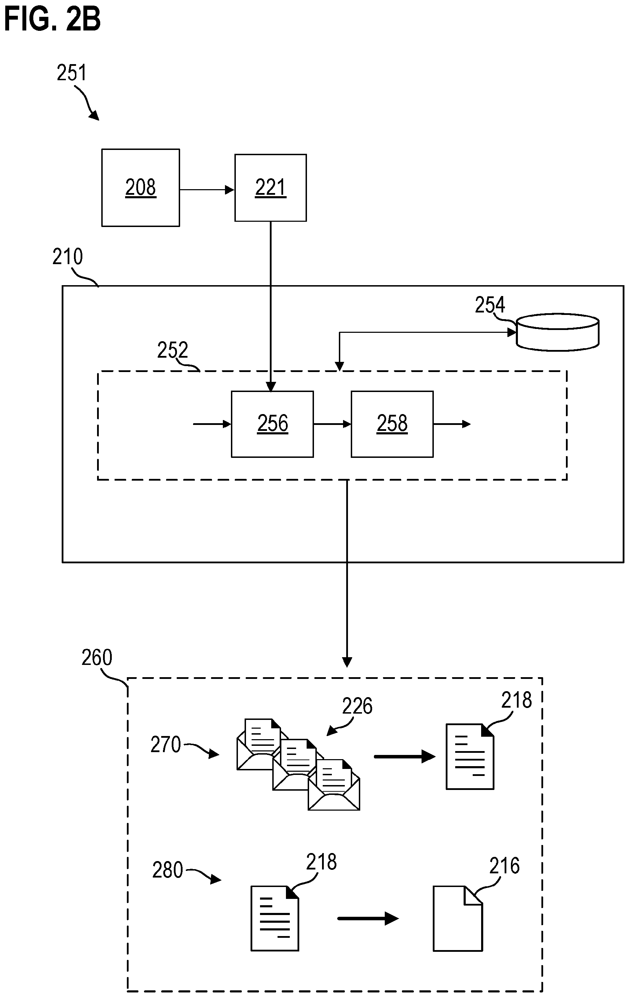

In a corresponding manner, the data may be decompressed and reconstructed at the end destination to which the compressed sensor data were transmitted. In this regard, **FIG.2B** shows a data decompression circuit 250 in a schematic view according to various aspects. The data decompression circuit 250 may include a processing circuit 252 and a memory 254 coupled to the processing circuit 252. The memory 254 may be arranged to store instructions (e.g., software instructions) executed by the processing circuit 252. The instructions may cause the processing circuit 252 to perform a method 260 of decompression of sensor data, which is described in further detail below. Aspects described with respect to a configuration of the processing circuit 252 may also apply to the method 260 and vice versa.

In general, the data decompression circuit 250 may be a dedicated device in an architecture that includes one or more sensors, e.g., in the IoT network 100. The data decompression circuit 250 may be part of a device or layer that receives the (compressed) sensor data. For example, the decompression circuit 250 may be part of the network layer of the IoT architecture, e.g., a gateway may include the decompression circuit 250. As another example, the decompression circuit 250 may be part of the processing layer of the IoT architecture. As mentioned above, the data decompression circuit 250 and corresponding method 260 may also be for use in contexts other than an IoT architecture, and may in general be applied in any suitable context.

In general, the decompression may be carried out at another entity with respect to the entity that compressed the data (e.g., an entity other than the sensor box). However in principle a configuration may be provided in which the data compression circuit 200 and the data decompression circuit 250 are part of the same entity. For example, a sensor box may include the data compression circuit 200 that compresses the sensor data and causes a storage of the compressed sensor data in a memory of the sensor box. The sensor box may further include a data decompression circuit 250 to decompress the stored compressed sensor data, e.g., to carry out further analysis on the data, to evaluate the quality of a sensor measurement, or for any suitable purpose for which decompressed data may be used.

The data decompression circuit 250 may be logically divided into a plurality of components, namely a decompressor 256 (also referred to as decompression circuit) and a de-sequencer 258 (also referred to as de-sequencing circuit). It is understood that the functionalities associated with the data decompression may be carried out by individual components or may be carried out by a plurality of components acting together. Stated in a different fashion, the decompressor 256 and de-sequencer 258 may be realized as separate circuits configured to implement a respective function, or as a single circuit configured to implement more than one function. It is also understood that, in principle, the data compression may be carried out by a plurality of circuits that are physically separated from one another and are communicatively coupled with one another (e.g., via a wired or wireless connection).

In general, the data decompression circuit 250 may be configured, according to the method 260, to carry out a decompression of sensor data compressed according to the approach proposed herein. In this regard, the data compression circuit 200 and the data decompression circuit 250 may be communicatively coupled with one another, e.g., directly or via one or more intermediate devices or layers. For example, the data compression circuit 200 may be in the perception layer of the IoT architecture, and the data decompression circuit 250 may be in the processing layer of the IoT architecture, so that the data compression circuit 200 may transmit the compressed data packets 226 to the network layer, and the network layer may forward the compressed data packets 226 to the data decompression circuit 250 in the processing layer. In a preferred configuration the data compression circuit 200 and the data decompression circuit 250 may be communicatively coupled with one another via a wireless connection, illustratively over a wireless communication channel.

The decompressor 256 may thus be configured to receive the plurality of compressed data packets 226 that contain the compressed sensor reading values. The decompressor 256 may further be configured to carry out a decompression of the compressed data packets 226 to reconstruct the sequenced sensor reading values 218. As mentioned, the compressed data packets 226 may include header information that represent a sequence number of the data packet. The decompressor 256 may extract the information representative of the sequenced sensor reading values 218 from the data slot of the compressed data packets 226 and may reconstruct the time sequence of the data based on the sequence number of the data packet.

The sequence number may also enable the decompressor 256 to determine that a compressed data packet 226 is missing, and request or prompt a further transmission of that sequence compressed data packet 226. Illustratively, the decompressor 256 may employ a simple procedure that reverses the received compressed data to its original values and format. In some aspects, the data decompression circuit 250 (e.g., the decompressor 256) may also have intelligence that enables the recovery of lost or corrupted packets due to the channel conditions, despite dealing with compressed data.

The decompressor 256 may reconstruct the sequenced sensor reading values 218 based on the information contained in the data slots in combination with the correct ordered sequence of the data packets. Illustratively, the decompressor 256 may use the information in the data slot to determine the sequenced sensor reading values 218. For example, in case of an empty data field the decompressor 256 may reconstruct that the previous sequenced sensor reading value should be repeated. As another example, in case of a data slot carrying information about a difference or delta, the decompressor 256 may reconstruct the sequenced sensor reading value by adding/subtracting the delta to the previous sequenced sensor reading value, etc. As a result of the decompression and reconstruction the decompressor 256 may provide, as output, the sequenced sensor reading values 218. The sequenced sensor reading values 218 may include a plurality of sets of sequenced sensor reading values 218 in case the data originated from a plurality of sensors, as discussed above.

In some aspects, the data decompression circuit 250 may further be configured to carry out a de-sequencing of the sequenced sensor reading values 218. Illustratively, the de-sequencer 258 may receive the sequenced sensor reading values 218 from the decompressor 256, and may be configured to convert the format of the sequenced sensor reading values 218 from the second format provided by the sequencer at the compression side into the first (original, e.g., raw) format of the corresponding sensor. Stated differently, the de-sequencer 258 may process the sequenced sensor reading values 218 to obtain the sensor reading values in the (first) representation prior to the sequencing, thus providing the sensor data 216 as output (or plurality of sensor data in case of multiple sensors). The decompressed (and de-sequenced) data may be the identical data in the original format, e.g., after undergoing the noise cancellation procedure. Illustratively, the decompressed (and de-sequenced) data may correspond to the noise-free raw sensor data.

From the point of view of the method 260, the method may include, in 270, receiving the compressed data packets 226 containing the compressed (sequenced) sensor reading values, and carrying out decompression of the compressed data packets 226 to reconstruct the sequenced sensor reading values 218. The method 260 may further include, in 280, carrying out a de-sequencing of the sequenced sensor reading values 218 to convert the second format of the sequenced sensor reading values 218 into the first format defined by the corresponding sensor to deliver, as output, the sensor data 216 represented with the first format.

The decompressed and de-sequenced sensor data 216 may be further processed, e.g., at the data decompression circuit 250 or at another processing circuit, e.g., to determine one or more instructions for one or more user applications or user services. Illustratively, the data decompression circuit 250 or a further processing circuit may analyze the information provided by the sensor data 216 to determine one or more actions to be carried out. For example, the decompression circuit 250 or further processing circuit may instruct one or more of the following actions based on the sensor data 216: a display of information to a user; an actuation of an actuator device; the triggering of a sensing process; an instruction of an IoT device; and the like. In general, the decompression circuit 250 or a further processing circuit may determine (e.g., generate) one or more instructions for controlling an operation of a further device based on the sensor data 216. For example, the result of the processing may be delivered to an application layer of the IoT architecture.

As shown in FIG.2B, the decompression circuit 250 may be aware of the compression profiles 221. Illustratively, the profiler 208 may share the same plurality of compression profiles 221 with both the data compression circuit 200 and with the decompression circuit 250. The plurality of compression profiles 221 may thus be synchronized between the compression side and decompression side. The decompression circuit 250 may make use of the compression profiles 221 for the decompression. For example, the decompressor 256 may be configured to carry out the decompression of the compressed sensor reading values based on the known compression profiles 221. Illustratively, the decompressor 256 may use the knowledge of the expected sizes of the data slots of the compressed data packets 226 to carry out the decompression.

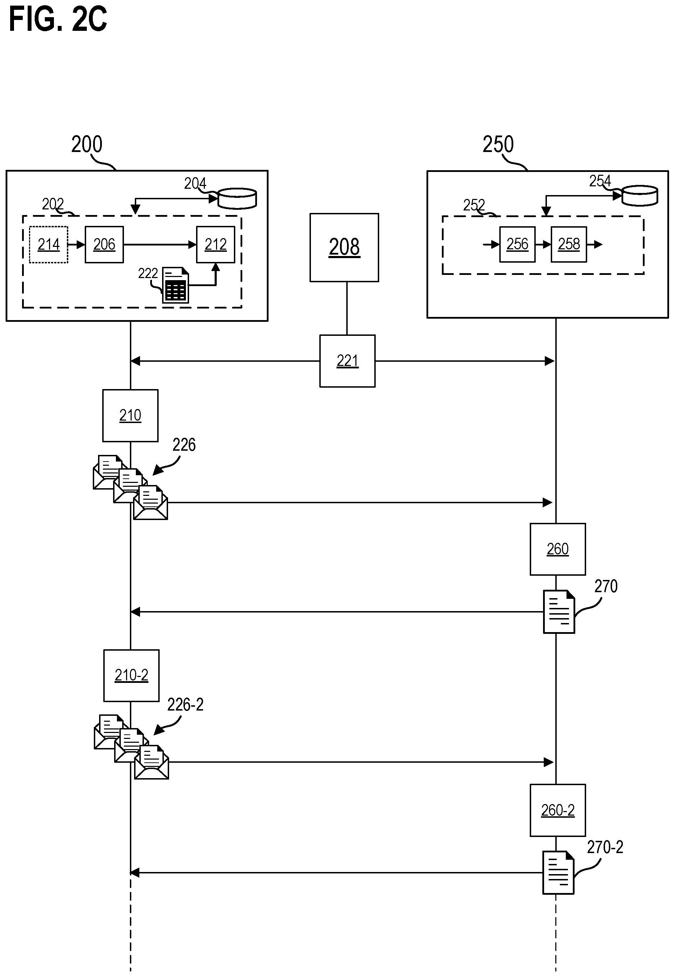

**FIG.2C** shows an exemplary exchange of data between a data compression circuit 200 and a decompression circuit 250. As shown, the profiler 208 may be common to both circuits. In this regard, the profiler 208 may be disposed at any suitable location within the system including the data compression circuit 200 and the decompression circuit 250. In general, it may be beneficial to have the profiler 208 at the decompression side, e.g., as part of the decompression circuit 250 or as part of the entity that includes the decompression circuit 250. Having the profiler 208 at the decompression side may allow the decompression circuit 250 to handle data from multiple compressors (e.g., multiple sensor boxes), while using a single profiler. It is however understood that in principle the profiler 208 may also be at the compressor side, or at any other suitable entity.

In general, the profiler 208 may be configured to determine the possible compression profiles 221 to be used for the sensor or sensors for which data compression should be carried out. Illustratively, the profiling operation carried out by the profiler 208 may include determining the possible combinations of data sizes for compressed sensor reading values from one or more sensors, and determining the possible combination of data sizes for different types of compressions (e.g., different mapping, or different algorithms), to obtain, as a result, a pool of compressed data formats suitable for the compression/transmission of sensor data by the sensors.

The profiler 208 may be configured to determine the compression profiles 221 in any suitable manner and using any suitable type of data. For example, the profiler 208 may be configured to determine the compression profiles 221 taking into consideration an environment of the sensors, such that each compression profile may be associated with certain environmental conditions. As an example, considering a sensor installed in a moving robot, a first compression profile may be associated with a stationary state of the robot, a second compression profile may be associated with a moving state of the robot, etc. As another example, a first compression profile may be associated with a first expected amount of incoming data (e.g., at night), a second compression profile may be associated with a second expected amount of incoming data (e.g., during the day), etc.

As mentioned above, the profiler 208 may in general carry out the profiling "offline", and act as a shared entity between compressor and decompressor to provide the compression profiles 221 to both sides. The output of the profiler 208 may thus include the compression profiles 221 synchronized between the compressor side and the decompressor side. In some aspects, the profiler 208 may further adapt the compression profiles 221 "on the fly", e.g., to change some of the compressed data formats, to add one or more additional profiles, to remove one or more of the profiles, etc. The adaptation may enhance the flexibility of the compression/decompression, although it may increase the resource consumption.

Turning back to the flow of information in FIG.2C, the data compression circuit 200 may carry out the compression 210 and transmit the compressed data packets 226 including the compressed sensor data to the data decompression circuit 250. In this regard, the transmission may include single data packets or batches of data packets. For example, the data compression circuit 200 may transmit individual compressed data packets 226, e.g., one after each sampling of the data from the sensor or sensors.

As another option, the data compression circuit 200 may refrain from transmitting the compressed data packets 226 after each sampling, and may rather accumulate multiple compressed data packets 226 to be transmitted together (e.g., as a single data packet formed by a plurality of compressed data packets). In this scenario, the data compression circuit 200 may store the prepared compressed data packets 226, group together compressed data packets 226 from a plurality of samplings, and may transmit the grouped compressed data packets 226 from the plurality of samplings (e.g., after a predefined number of samplings, after a certain time, etc.).

The data compression circuit 200 may carry out the decompression 260 to obtain the decompressed data, as discussed above.

In general, various options exist for the relationship between the compression side and the decompression side. In a simple configuration, there may be an unidirectional relationship, in which the data compression circuit 200 has no knowledge about the state of the decompression circuit 250 or of the results of the decompression process. In a more complex configuration, there may be bidirectional communication between the compression side and the decompression side.

As shown in FIG.2C, in various aspects the decompression circuit 250 may be configured to transmit feedback information 270 to the data compression circuit 200. The feedback information 270 may be representative of a quality of the decompression of the compressed sensor data. For example, the feedback information 270 may indicate whether the decompression circuit 250 could receive and interpret all the compressed data packets 226, may indicate a grade of complexity of the decompression and/or a grade of complexity of the reconstruction, and the like. The feedback information 270 may thus generally represent a performance of the decompression.

For example, the decompression circuit 250 may transmit the feedback information 270 after each reception of compressed data packets 226 (and corresponding decompression). As another example, the decompression circuit 250 may transmit the feedback information 270 after a plurality of receptions of compressed data packets 226, e.g., providing an indication of an average quality of the data decompression.

The data compression circuit 200 may receive the feedback information 270, and may be configured to change one or more parameters of the data compression based on the feedback information 270. Illustratively, the data compression circuit 200 may use the feedback information 270 to identify one or more parameters to be adapted to provide higher quality for the next data decompression. In this regard, the data compression circuit 200 may act on any suitable parameter related to the data compression. For example, the sequencer 206 may use a different "second" format for representing the raw data. As another example, the compressor 212 may select a different profile 222, or may use different combinations of data formats from the selected profile.

As a further example, the compressor 212 may use a different compression, e.g., a different mapping or a different algorithm, etc.

In some aspects (not shown), the exchange of information may occur between two devices that are capable of carrying out both data compression and data decompression. Illustratively, a first device may include a data compression circuit 200 and a decompression circuit 250, and may communicate with a second device that includes a further data compression circuit 200 and a further decompression circuit 250. In this scenario, the feedback information may be appended to the compressed data packets exchanged between the devices instead of being separately transmitted.

As shown in FIG.2C, the data compression circuit 200 may then carry out a further data compression 210-2 using the changed one or more parameters, to provide further compressed data packets 226-2. At the decompression side, the further compressed data packets 226-2 may be decompressed in a further decompression 260-2, to then provide further feedback information 270-2, etc. The use of feedback information may increase the complexity of the system, but may ensure a more robust process and overall a higher quality of the data compression/decompression.

In the following, further aspects of the sequencer (FIG.3), profiler, and compressor (FIG.4) will be described. It is understood that the aspects discussed in relation to FIG.3 and FIG.4 may apply to the configuration of FIG.2A, and vice versa.

FIG.3 shows a sequencing process 300 in a schematic representation, according to various aspects. In the sequencing process 300, a sequencer 306 may receive sensor data 216, carry out a sequencing to convert the representation of the sensor data 216, and deliver, as output, sequenced sensor reading values 218 (illustratively, sequenced sensor data). The sequencer 306 may generally be configured as the sequencer 206 described in relation to FIG.2A. It is understood that the aspects discussed in relation to the sequencing process 300 and sequencer 306 apply in a corresponding manner to the sequencer 206, and vice versa.

It is also understood that FIG.3 refers to the exemplary scenario of a sequencer 306 ($S_i$) for the sequencing of sensor data 216 from one sensor (or in general from one data source 301), but the aspects discussed in relation to FIG.3 may extend to a scenario with a plurality of sequencers 306, each dedicated to a respective sensor of a plurality of sensors to receive and sequence the corresponding sensor data from the associated sensor. Illustratively, the sequencing process 300 may include a set of sequencers 306, and the cardinality of sequencers is generally equal to the cardinality of sources of sensor data (e.g., equal to the cardinality of sensors).

As a preliminary and optional step, the sequencing 300 may include a noise reduction. In this regard, a noise reduction circuit 314 may receive the sensor data 216, carry out a noise reduction process (e.g., a filtering), and deliver a noise-reduced version of the sensor data to the sequencer 306, as discussed in relation to the noise reduction circuit 214 in FIG.2A. Illustratively, at a first step of the data compression, a noise reduction and pre-processing may take place using the raw sensor readings generated by the data source 301 (or each of the data sources in case of multiple sensors). The data source 301 may be denoted with $D_i$, where $i \in \{1,..., N\}$, N >= 1. The data source 301 may be a sensor of any suitable sensor type, or the data source 301 may include a processor delivering the sensor data 216, e.g., after fusion of sensor data from multiple sensors. An example, of sensor fused data may be data representative of an orientation, which may be derived from the accelerometre and gyroscope data.

The sensor reading values from the data source 301 may be denoted as $f_i(t_k)$, to indicate the sensor reading from $D_i$ at time $t_k$, in preparation for transmission number $k$. Illustratively, $f_i(t_k)$ may denote the sensor reading value or values for transmission during the k-th instance of data transmission. The noise reduction circuit 314 may employ any suitable noise removal technique or filter. As an example, the noise reduction circuit 314 may use a high-pass filter on the deltas to smooth or filter out noise in the least significant part of the data while preserving the significant part. The noise-reduced version of the sensor reading value(s) may be denoted as $f_i'(t_k)$.

According to various aspects, the sequencer 306 may be communicatively coupled with a sequencer oracle 303. For example, the sequencer oracle 303 may be part of the data compression circuit that includes the sequencer 306 (e.g., the data compression circuit 250), e.g., the sequencer oracle 303 may be part of the sequencer itself or may be external to the sequencer. In general, the sequencer oracle 303 may include one or more processors, and may be configured to determine (e.g., define, select) a rule for converting the representation of the sensor data 216 from the first (raw) format into the second format that facilitates the compression of the data. In case of multiple sensor data from multiple sensors, a dedicated sequencer oracle per each sensor (or data source) may be provided, e.g., one sequencer oracle per each sequencer.

The sequencer oracle 303 may thus be understood as a circuit capable of identifying how to transform the sensor data 216 into a format that facilitates the subsequent lossless compression. Stated differently, the sequencer oracle 303 may be configured to identify the transformation of the sensor data 216 to obtain a representation (with the second format) that allows representing the sensor reading values (and their evolution over time) in way that the compression expects to receive.

The sequencer oracle 303 may be configured to identify the second format to be used by the sequencer 306 for converting the representation of the sensor reading values. Illustratively, the sequencer oracle 303 may be configured to determine how to represent the sensor reading values (as sequenced sensor reading values 218) to convey/represent the same information with a format that the compressor supports. According to various aspects, the sequencer oracle 303 may be configured to define the second format based on a length of a data slot in an uncompressed data packet containing the sensor reading values. The sequencer oracle 303 may define the second format to allow the compressor to obtain a reduction of the required length of the data slot compared to the uncompressed data packet and uncompressed representation of the sensor data.

The sequencer oracle 303 may thus define a corresponding rule for converting the sensor data 216 from the first format into the second format, and the choice of the rule (illustratively, the choice of the sequencing method) may depend on the characteristics of the sensor data. For example, sensor reading values with small variations may be represented with a format that exploits the relative difference between consecutive values. Sensor reading values that do not vary over certain periods of time may be represented with a format that exploits the static nature of the data, etc.

The sequencer oracle 303 may be capable of identifying how to convert any type of incoming sensor data into a format that is uniformly handled during the compression process. The sequencer oracle 303 may help representing the data in the best suited format for the compression, thus yielding a more resource- and time-efficient result compared to conventional approaches. With reference to FIG.3, considering noise reduction, the sequencer oracle 303 may generate the rule to be followed by the sequencer 306 $S_i$ based on the input $f_i'(t_k)$. The sequencer 306 $S_i$ then rewrites the data $f_i'(t_k)$ using the format dictated by the sequencer oracle. As output, the sequencer 306 may deliver the sequenced reading values 218, e.g., noise-reduced and pre-processed sensor reading from the data source 301. The sequenced reading values 218 may be denoted as $S_i[f_i'(t_k)]$, and may be referred to as sequenced octet or sequenced octets.

Considering a plurality of sensors or data sources, the output of the sequencing may include a plurality of outputs as $S_i[f_i'(t_k)], \ldots, S_N[f_N'(t_k)]$. In this scenario, the sequencer 306 may deliver a vector $V_{(t_k)}$ including the sequenced sensor reading values from multiple sensors to the profiler and compressor for the further steps of the data compression. For example, the vector $V(t_k)$ may assume the form

$$V(t_k) = [\beta, S_i[f_i'(t_k)], \ldots, S_N[f_N'(t_k)]] \quad ,$$

where $\beta$ refers to the allocated memory for metadata or padding needed to deliver enough information regarding the sequence of outputs from the sequencing. For example, the compressor may include the padding in case it is sending uncompressed packets (identify transformation, e.g., for resetting the decompressor context after an error, as an example).

As mentioned above, the type of sequencing may be adapted depending on the characteristics of the sensor data and sensor reading values, and may vary from one sensor to another in view of the specific nature of the data acquisition, behavior of the sensed quantity, type of raw representation, and the like.

As an example, which was found to provide a particularly suitable way of representing sensor data, the sequencer oracle 303 may be configured to determine an exponent suitable for representing all the sensor reading values of the sensor data 216. The sequencer 306 may then represent the sensor reading values using the exponent and a respective mantissa for each sensor reading value. Such representation may be particularly beneficial in case of a floating-point representation of the sensor data 216, as it provides a standardized second representation. For example, with a mantissa-based representation it may be easier to see a difference (a delta) between consecutive sequencer reading values. For floats the benefit may be independence from architecture and the usage of integer operations instead of floating points ones during compression.

Only as a numerical example, considering a time series of temperature values as sensor reading values, e.g., [25101.0; 25101.0; 25101.0; 25101.0; 25091.0; ...], where the values in degree Celsius are expressed with a 100x multiplier, the sequencer 306 may determine that all the values may be represented with exponent 5 and a respective mantissa, and all the values may fit a 2-Byte storage (illustratively, the representation may be forced into a predefined number of Bytes, e.g., 2 in this case).

Another example of sequencing may include the use of a dictionary (e.g., of a look-up table). In this scenario, the sequencer oracle 303 may define entries of a dictionary based on the sensor reading values, and the sequencer 306 may retrieve the corresponding sequenced reading values from the dictionary based on the entries (illustratively, the keys) defined by the sequencer oracle 303. A further example of sequencing may include Huffman coding. In this scenario, the sequencer oracle 303 may define a Huffman code to represent the sensor reading values, and the sequencer 306 may use the Huffman code to define the sequenced sensor reading values 218.

The identification by the sequencer oracle 303 of how to convert the representation of the sensor data 216 may be carried out in any suitable manner. In a preferred configuration that may allow a robust and time-efficient approach, the sequencer oracle 303 may be configured to use a trained machine learning model to determine the rule for converting the sensor reading values into the second format. Illustratively, the trained machine learning model may receive, as input, the sensor reading values and may deliver, as output, the rule to be applied by the sequencer 303 for converting the sensor reading values into the second format.

The machine learning model may be trained with historic sensor data for the sensor with which the sensor reading values are associated, illustratively with previous sensor reading values from that sensor, an actual result and a target result. The target result may represent a data size or a range of data sizes (e.g., a range of bits) that may be considered acceptable for data represented using the second format. The actual result may represent a data size obtained by a certain representation of the sensor reading values. The training may include multiple iterations of the machine learning model defining different representation of the sensor reading values until the actual result corresponds to the target result, or until the actual result deviates from the target result by a predefined amount. In some aspects, the training may be carried out using part of the sensor reading values to be compressed. In this scenario, a portion of the sensor data 216 may be used for training the machine learning model until the proper rule is identified, and then the trained machine learning model may be applied to the sensor data 216 (all the sensor data 216, or the remaining portion of the sensor data 216) to define the rule to be used by the sequencer 306.

Machine learning is however not the only option to identify the sequencing rule. In other aspects, additionally or alternatively, the sequencer oracle 303 may use a predefined rule for that sensor or that sensor type. This approach may be more computationally simple, and may be based on the realization that sensor data from a certain sensor or from a certain type of sensor may have generally the same behavior over the lifetime of the sensor. Thus, the rule for converting the format of the sensor reading values from a certain sensor may be defined once, e.g., at fabrication or when the sensor is put into operation, and the defined rule may be used over the lifetime of the sensor for the format conversion of the sensor data.

As a further example, additionally or alternatively, the sequencer oracle 303 may receive a user input representative of the rule to be applied for the sequencing. This approach may exploit the knowledge of the user regarding which format works better for sensor data from a certain sensor or a certain sensor type.

FIG.4 shows a profiling and compression process 400 in a schematic representation, according to various aspects. In the process 400, a compressor 412 may receive sequenced sensor data 218, and carry out a lossless compression based on a compression profile 422 selected from a plurality of compression profiles defined by a profiler 408. The profiler 408 and compressor 412 may generally be configured as the profiler 208 and compressor 212 described in relation to FIG.2A. It is understood that the aspects discussed in relation to the process 400, profiler 408, and compressor 412 apply in a corresponding manner to the profiler 208 and compressor 212, and vice versa.

It is also understood that FIG.4 refers to the exemplary scenario of a compression of sequenced sensor data 218 from one sensor, but the aspects discussed in relation to FIG.4 may extend to a scenario with a plurality of sets of sequenced sensor data 218, each associated with a respective sensor of a plurality of sensors. In this case, the input to the compressor 412 may be the vector $V_{(tk)}$ including the sequenced sensor reading values from multiple sensors.

Furthermore, the configuration in FIG.4 shows exemplary components for the compressor 412 (e.g., a parser 432, a rule applicator 434, and an assembler 436), but it is understood that the compressor 412 may include additional, fewer, or alternative components. Illustratively, the functionality of the compressor 412 may be realized with any suitable number of components, and with any suitable logical sub-division of the components. It is also understood that the aspects related to the profiler 408 discussed in relation to FIG.4 are not linked to the specific configuration of the compressor 412, and may apply in a corresponding manner to any suitable configuration of the compressor 412 (e.g., any suitable configuration of the compressor 212).

In general, the compressor 412 may be configured to select one of the compression profiles 422 based on a compression context 440, e.g., based on one or more target parameters to be achieved with the data compression. Illustratively, the compressor 412 may be configured to determine (e.g., find, identify, select) the compression profile 422 that allows obtaining one or more target parameters, or at least allows obtaining a deviation from the one or more target parameters within an acceptable range. The target parameters may be selected based on desired properties of the data compression and of the overall operation of a system including the sensors, e.g., a desired performance of an IoT architecture.

As an example, the compressor 412 may be configured to determine the compression profile 422 to be used by identifying the compressed data formats based on a (target) data packet size and on a (target) predefined robustness of a data transmission of the compressed data packets. Illustratively, the compressor 412 may be configured to determine the compression profile 422 that minimizes the data packet size (e.g., the total summed packet size of the packets to be transmitted), while maximizing the robustness of the data transmission. Maximizing the robustness of the data transmission may include, for example, minimizing a number of packets lost during the transmission, minimizing a number of packets corrupted during the transmission, or any other suitable metrics of reliability.

According to various aspects, the data compression may take into consideration the conditions of a communication channel between the entity at which the data compression is carried out (e.g., the sensor box 150), and the entity to which the compressed data packet should be transmitted (e.g., a gateway of the network layer). Illustratively, the selection of the compressed data formats may be based on channel-related information (referred to herein as channel parameter observations), illustratively information representative of the communication channel via which the compressed data packets 226 are transmitted. The channel parameter observations may include a list of metrics that are taken into account when choosing the compressed data formats to achieve robustness in the presence of losses in the channel.

In this regard, the term "communication channel" may describe a physical link or connection between two entities. A "communication channel" may thus include a physical medium over which the two entities communicate with one other. The physical medium may physically support and transport the information that is transmitted/received via the "communication channel". The physical medium may depend on the type of communication, e.g., the physical medium may include air, an electrically conductive wire, an optical fiber, and the like. A "communication channel" may describe a physical medium or a part of the physical medium for communication between devices. In various aspects, a "communication channel" may cover a certain spectral bandwidth within a frequency band.

The channel-related information may include any suitable type of information representative of communication-related parameters that may be influenced by the conditions of the communication channel. As examples, the channel-related information may include an error rate, a noise level, a predefined robustness, feedback information, a number of other devices that use the same channel for communication, and the like. The compressor 412 may determine the profile 422 that is most suitable for the specific channel conditions, e.g., to reduce (e.g., minimize) an error rate below a predefined error threshold, reduce (e.g., minimize) an influence of noise below a predefined noise threshold, enhance (e.g., maximize) robustness above a predefined robustness threshold, etc. The used channel-related information may provide a further tailoring of the data compression to the actual scenario in which the compression/transmission takes place, thus further enhancing the overall efficiency of the process. It is however understood that the data compression may be carried out also in absence of channel-related information, or without taking such information into account.

In general, the compressor 412 may use compression-related information 442 for selecintg the compression profile 422. The compression-related information 442 may include any suitable information relevant for the compression process. The compression-related information 442 may thus include the channel-related information described above, information regarding the state of the sensors, information regarding the state of an entity containing the sensor (e.g., a robot being stationary or moving), information regarding the environment, feedback information from the decompression circuit, and the like.

According to various aspects, additionally or alternatively to using compression-related information 442, the compressor 412 may be configured to select the compression profile 422 based on historic data 444 representative of previous sensor data (e.g., previous sensor reading values). The historic data 444 may represent sensor data from previous measurements by the sensor or sensors for which the current instance of data compression should be carried out. The compressor 412 may use the historic data 444 to identify which compressed data formats worked for that sensor or sensor type, and apply those compressed data formats to the currently available sensor data and sequenced sensor reading values 218. The use of historic data 444 may simplify the search for the compression profile 422 to be used, by exploiting already available information.

The historic data 444 may illustratively include a reference matrix including sensor reading values and/or sequenced sensor reading values associated with one or more previous instances of data transmission. Such matrix may be denoted as $R(l, t_k) := [V(t_{k-1}) ... V(t_{k-l})]$. The compressor 412 may for example search for a compression profile that would have achieved the target parameters for the historic data 444 and apply the same profile for the currently available data.

In some aspects, additionally or alternatively to using compression-related information 442 and/or using historic data 444, the compressor 412 may be configured to select the compression profile 422 based on the predefined size of the data used by the sequencer for defining the conversion into the second format. Illustratively, the compressor 412 may select the compressed data formats to use (and corresponding size of the data field) based on the predefined number of bytes (or bits) into which the sequencer converted the representation of the sensor reading values. For example, the compressor 412 may select compressed data formats having a data field with size that is equal to or less than the predefined number of bytes (or bits). As another example, for sensor data from multiple sensors, the compressor 412 may select compressed data formats having a data field with size that is an integer multiple of the predefined number of bytes (or bits). Taking the predefined data size into account allows optimizing the overall size of the data packets to be transmitted.

Turning to the profiler 408, it may be configured to determine the pool of possible compression profiles in any suitable manner, as discussed above. In this regard, the profiler 408 may make use of any suitable data. For example, the profiler 408 may be configured to determine the plurality of compression profiles using the compression-related information 442 (e.g., the channel information). Additionally or alternatively, the profiler 408 may be configured to determine the plurality of compression profiles using the historic data 444, or any other suitable information.

The profile oracle 408 may have a knowledge of the maximum length handled by the sequencer to generate accordingly the right profiles for compression that are available for selection by the compressor 412. For example, the profile oracle may overlap values in fields, e.g., different sensor values (such as temperature and pressure) could be written on the same field, e.g., temperature (1 byte), pressure (1 byte) may be written using 1 byte only.

The identification by the compressor 412 of the suitable compression profile 422 may be carried out in any suitable manner. In a preferred configuration that may allow a reliable and time-efficient approach, the compressor 412 may be configured to use a trained machine learning model to determine the compression profile 422. Illustratively, the trained machine learning model may receive, as input, the sequenced sensor reading values 218 to be compressed and delivers, as output, the compression profile 422 to be used for the lossless compression (illustratively, for preparing the data for transmission using the corresponding compressed data packets).

The machine learning model may be trained with historic sensor data for the sensor with which the (sequenced) sensor reading values are associated, illustratively with previous sensor reading values from that sensor, an actual result and a target result. The target result may represent any desired parameter to be optimized, e.g., a robustness of the data transmission, an error rate, a data size or a range of data sizes for the compressed data packets, and the like. The actual result may represent the parameters obtained by a certain compression profile. The training may include multiple iterations of the machine learning model defining different compression profiles until the actual result corresponds to the target result, or until the actual result deviates from the target result by a predefined amount.

In some aspects, the training may be carried out using historic data 444 associated with the sensor or sensors from which the sensor data to be compressed originated. In some aspects, the training may be carried out using part of the sequenced sensor reading values to be compressed. In this scenario, a portion of the sequenced sensor reading values 218 may be used for training the machine learning model until the proper compression profile 422 is identified, and then the trained machine learning model may be applied to the sequenced sensor reading values 218 (all the sequenced sensor reading values 218, or the remaining portion of the sequenced sensor reading values 218) to define the compression profile 422.

In some aspects, the machine learning model may include a neural network or a plurality of neural networks. Machine learning and neural networks may be used also for the initial definition of the available compression profiles. For example, the profiler 408 may be derived using neural networks on a large set of data collected initially from the N data sources (e.g., the N sensors).

Machine learning is however not the only option to determine the compression profile 422. In other aspects, additionally or alternatively, the compressor 412 may use another type of algorithm that searches for the compression profile 422 suitable for the sequenced sensor data 218. For example, the compressor 412 may carry out an exhaustive search to find the combination of compressed data formats for the sequenced sensor data 218. The exhaustive search may include determining the result obtained with each possible combination of the available compressed data formats, and select the compression profile 422 that provides a result fulfilling a predetermined criterion (e.g., a minimization of the overall size, a maximization of robustness, etc.). This approach may be more time-consuming, but may dispense with the training and setting of a machine learning model.

As a further example, additionally or alternatively, the compressor 412 may receive a user input representative of the compression profile 422 to be used for preparing the sequenced sensor reading values 218 for transmission. This approach may exploit the knowledge of the user regarding which data formats work for sensor data from a certain sensor or a certain sensor type.

The compressor 412 may then carry out the compression of the sequenced sensor reading values 218 using the compression profile 422. In general, the compression profile 422 may include one or more profiles where each profile includes a plurality of compressed data formats. For example, each profile may include an ordered list of compressed data formats in a descending order of packet lengths. For example, each profile may be related to a certain state of the sensor, or a certain state of a machine including the sensor. Only as an example, considering a sensor installed in a robot, a first profile may be related to an idle state of the robot, a second profile may be related to an operating state of the robot, and the like.

In this regard, the compressor 412 may include a parser 432 that may be configured to separate the continuous memory into various comparable fields. The parser 432 may output parsed data 452 ("parsed $V(t_k)$") which may represent a parsed representation of the sensor data (and sequenced sensor reading values 218), e.g., for one sensor or multiple sensors. In this connection, in some aspects the reference matrix may include an array of "parsed V(tk)" which contains at least one element representing a previous sensor reading. The parser 432 may be provided for efficiency and simplicity of implementation. With and without parser, the reference matrix's size in memory may be comparable. But without parser, the reference matrix is stored in an unparsed state, such that for each consecutive compression step using the reference(s), the reference(s) have to be parsed again, thus potentially wasting cycles in a resorce contrained systems.

The compressor 412 may further include a rule applicator 434 that may be configured to find the compressed data format that provides the smallest size of the data slot(s) and delivers sufficient information to achieve the required reliability. The rule applicator 434 may rely on any available information for identifying the rule to be applied (e.g., channel information, feedback information, etc.). The rule applicator 434 may output a selected rule identifier 454, which represents the chosen compressed data format. In case of multiple profiles (e.g., as discussed for the robot), this is where the rule applicator takes the relevant parameter into account (e.g., motion/idle). The compressor 412 may further include an assembler 436 that may be responsible for creating the compressed data packet(s) based on the identified formats. The assembler 436 goes through all N sequenced sensor readings and the connected references (if applicable) and one by one applies the compression on the specific sensor reading based on the chosen compressed data format (rule id selected by rule applicator). The output is the compressed packet, which is the aggregate of all N compressed sensor readings and metadata.

There may be some assumptions for the data compression. For example, throughout the entire procedure the system may be aware of all data sizes, whether compressed or uncompressed (raw). As a further example, the last element of the compression profiles (the last compressed data format) may be an identity transformation, which the rule applicator chooses if no other rule fits or if the decompressor has to be synchronized. This means that the data may be transmitted uncompressed (uncompressed packet and metadata). The final compressed data representation may be denoted as $v(t_k) =$

$$[\beta', \ s_1[f_1'(t_k)], ..., s_i[f_i'(t_k)], ..., s_N[f_N'(t_k)]],$$

where $s_i[f_i'(t_k)]$ is the compressed version of $S_i[f_i'(t_k)]$ of the data source #i. The metadata $\beta$ may contain fields such as the compressed data format ID, the sequence number, and the context identifier, CRC, etc.

In summary, the approach proposed herein achieves lossless data compression in a manner that is independent on the type of sensor, and in a manner that may enable fast and real-time data compression. In some aspects, the data compression may include six steps. The first four steps (i.e., noise reduction, sequencing, profiling, data compression) may be carried out at the entity responsible for the data compression (e.g., the sensor box). The final two steps (decompression and de-sequencing) may be carried out elsewhere in the system, e.g., at the end destination for the sensor data. For example, the first four steps may happen at the IoT sensor level, and the last two steps happen at the edge, or on the cloud.

The term "processing circuit" as used herein may be understood as any kind of technological entity that allows handling of data. The data may be handled according to one or more specific functions that the "processing circuit" may execute. Further, a "processing circuit" as used herein may be understood as any kind of circuit, e.g., any kind of analog or digital circuit. A "processing circuit" may thus be or include an analog circuit, digital circuit, mixed-signal circuit, logic circuit (e.g., a hard-wired logic circuit or a programmable logic circuit), microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. In some aspects, a "processing circuit" may be understood as a software-based implementation of the functionalities carried out by the processing circuit.

The term "memory" as used herein may be understood as a computer-readable medium (e.g., a non-transitory computer readable medium) in which data or information can be stored for retrieval. References to "memory" included herein may thus refer to volatile or non-volatile memory, including random access memory (RAM), read only memory (ROM), flash memory, solid state storage, magnetic tape, hard disk drive, optical drive, among others, or any combination thereof. Registers, shift registers, processor registers, data buffers, among others, are also embraced herein by the term memory.

The word "exemplary" is used herein to mean "serving as an example, instance, or illustration". Any aspect or configuration described herein as "exemplary" is not necessarily to be construed as preferred or advantageous over other aspects or configurations.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. Unless specified otherwise, the term "subset" in relation to a group of elements may be understood to include a numerical quantity equal to or greater than one and less than a total number of the implied elements. Considering for example a group of ten elements, a "subset" of the group may include one, two, three, four, five, six, seven, eight, or nine elements. The term "subset" in relation to a group may thus describe a "proper subset" of the group, so that all the elements of the subset belong to the group, but at least one element of the group does not belong to the subset.

The term "transmit" as used herein may include both direct (point-to-point) and indirect transmission (via one or more intermediary points). Similarly, the term "receive" may include both direct and indirect reception. Furthermore, the terms "transmit," "receive," "communicate," and other similar terms may include both physical transmission (e.g., the transmission of radio signals) and logical transmission (e.g., the transmission of digital data over a logical software-level connection). In general, the term "communicate" may include the exchange of data, e.g., unidirectional or bidirectional exchange of data.

Implementations of methods described herein may be demonstrative in nature and may be implemented in a corresponding device. In a corresponding manner, implementations of devices or circuits described herein may be implemented with a corresponding method. It is thus understood that a device or circuit corresponding to a method may include one or more components configured to perform each aspect of the related method.

All acronyms defined in the above description additionally hold in all claims included herein.

While the invention has been particularly shown and described with reference to specific aspects, it should be understood by those skilled in the art that various changes in form and detail may be made therein without departing from the scope of the invention as defined by the appended claims.

**Claims**

1. A method (210) of lossless compression of sensor data, the method comprising:

   receiving sensor data (216) comprising a plurality of sensor reading values, wherein the sensor data (216) are associated with a corresponding sensor;
   converting a format for representing the sensor reading values from a first format defined by the corresponding sensor into a second format;
   providing (220) the sensor reading values as sequenced sensor reading values (218) represented with the second format;
   selecting (230), from a plurality of predetermined compression profiles (221), a compression profile (222) for carrying out a lossless compression of the sequenced sensor reading values,
   wherein the compression profile (222) comprises a plurality of compressed data formats (224),
   wherein each compressed data format (224) defines a respective size of a data slot for transmitting one or more of the sequenced sensor reading values (218);
   carrying out (240) a lossless compression of the sequenced sensor reading values (218) to obtain compressed sensor reading values,
   wherein the second format is a data format supported by the lossless compression; and
   preparing the compressed sensor reading values for transmission using the compressed data formats (224) defined by the compression profile.

**2.** The method (210) according to claim 1, wherein preparing the compressed sensor reading values for transmission comprises providing compressed data packets (226) that contain the compressed sensor reading values according to the compression profile (222).

**3.** The method (210) according to claim 1 or 2, further comprising:
causing a transmission of the compressed data packets (226) containing the compressed sensor reading values.

**4.** The method (210) according to any one of claims 1 to 3, further comprising:

receiving feedback information representative of a quality of a decompression of the compressed sensor reading values;
changing one or more parameters associated with the lossless compression of the sensor reading values based on the received feedback information; and
carrying out a lossless compression of further sensor data using the changed one or more parameters.

**5.** The method (210) according to any one of claims 1 to 4,
wherein converting a format for representing the sensor reading values comprises using a trained machine learning model that receives, as input, the sensor reading values and delivers, as output, a corresponding rule for converting the representation of the sensor reading values into the second format.

**6.** The method (210) according to any one of claims 1 to 5,
wherein selecting the compression profile (222) comprises identifying the compressed data formats based on a target data packet size for the compressed data packets and a target robustness of a data transmission of the compressed data packets.

**7.** The method (210) according to any one of claims 1 to 6,
wherein selecting the compression profile comprises using a trained machine learning model that receives, as input, the sequenced sensor reading values to be compressed and delivers, as output, the compression profile to be used for the lossless compression of the sequenced sensor reading values.

**8.** The method (210) according to any one of claims 1 to 7,
wherein the sensor data (216) comprises a plurality of sensor data associated with a plurality of corresponding sensors; and
wherein carrying out the lossless compression of the sequenced sensor reading values comprises providing at least one compressed data packet that contains compressed sensor reading values associated with different sensors.

**9.** A computer program product comprising instructions which, when the program is executed by a computer, cause the computer to carry out the method of any one of claims 1 to 8.

**10.** A method (260) of decompression of sensor data compressed according to the method of any one of claims 1 to 8, the method of decompression comprising:

receiving (270) the plurality of compressed data packets containing the plurality of compressed sensor reading values; and
carrying out (280) a decompression of the compressed data packets to reconstruct the sequenced sensor reading values (218).

**11.** The method (260) according to claim 10, further comprising, after the decompression of the compressed data packets:
converting the format of the sequenced sensor reading values from the second format into the first format defined by the corresponding sensor.

**12.** A computer program product comprising instructions which, when the program is executed by a computer, cause the computer to carry out the method of any one of claims 10 to 11.

**13.** A data compression circuit (200) comprising:

• a sequencer (206) configured to:

receive sensor data (216) comprising a plurality of sensor reading values, wherein the sensor data (216) are associated with a corresponding sensor;
convert a format for representing the sensor reading values from a first format defined by the corresponding sensor into a second format; and
deliver, as output, the sensor reading values as sequenced sensor reading values (218) represented with the second format; and

• a compressor (212) configured to:

select, from a plurality of predetermined compression profiles (221), a compression profile (222) for carrying out a lossless compression of the sequenced sensor reading values (218),

wherein the compression profile (222) comprises a plurality of compressed data formats (224),

wherein each compressed data format (224) defines a respective size of a data slot for transmitting one or more of the sequenced sensor reading values (218);

carry out a lossless compression of the sequenced sensor reading values (218) to obtain compressed sensor reading values; and

prepare the compressed sensor reading values for transmission using the compressed data format (224) defined by the compression profile (222),

wherein the second format is a data format supported by the compressor (212).

**14.** A sensor box (150) comprising:

the data compression circuit (200) according to claim 13; and

one or more sensors (152), wherein each sensor (152) is configured to generate respective sensor data and deliver the sensor data to the data compression circuit (200).

**15.** The sensor box (150) according to claim 14,

wherein the plurality of sensors (152) comprises a first sensor (152-1) of a first sensor type and a second sensor (152-2) of a second sensor type, and

wherein the first sensor type is different from the second sensor type.

# FIG. 1A

100

132

132

130

120

102

| | |
|---|---|
| 102-1 | 102-2 |
| 102-3 | 102-4 |
| 102-5 | 102-N |

110

# FIG. 1B

150

152

| 152-1 | 152-2 | ---------------- | 152-N |

| 154 | 156 |
| 158 |

160

# FIG. 2A

# FIG. 2B

251

208 → 221

210

254

252

256 → 258

260

270

226

218

280

218 → 216

# FIG. 2C

EP 4 742 543 A1

**FIG. 3**

# FIG. 4

European Patent Office

Europäisches Patentamt
European Patent Office
Office européen des brevets

# EUROPEAN SEARCH REPORT

**Application Number**

EP 24 21 1763

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 631 055 B2 (WEGENER ALBERT W [US]; SAMPLIFY SYSTEMS INC [US]) 14 January 2014 (2014-01-14) * column 2, line 34 - line 36; figures 2, 10-14 * * column 5, line 27 - line 35 * * column 7, line 58 - line 59 * * column 11, line 7 - column 1, line 42 * * column 14, line 37 - line 64 * * column 15, line 1 - line 4 * * column 18, line 55 - line 60 * | 1-15 | INV. H03M7/30 H04B14/00 |
| A | US 2024/111439 A1 (PAVLICHIN DMITRI [US] ET AL) 4 April 2024 (2024-04-04) * paragraph [0020] - paragraph [0054] * | 1-15 | |
| A | US 9 118 345 B2 (ALTERA CORP [US]) 25 August 2015 (2015-08-25) * column 4, line 35 - column 6, line 65; figures 1,2 * * column 16, line 40 - column 22, line 38; figures 11,12 * | 1-15 | |
| A | WO 2016/186563 A1 (ZEROPOINT TECH AB [SE]) 24 November 2016 (2016-11-24) * paragraph [0080] - paragraph [0133] * | 1-15 | TECHNICAL FIELDS SEARCHED (IPC) H03M H04B H04N H04W |

The present search report has been drawn up for all claims

| Place of search | Date of completion of the search | Examiner |
|---|---|---|
| The Hague | 2 April 2025 | Belardinelli, Carlo |

EPO FORM 1503 03.82 (P4C01)

**EP 4 742 543 A1**

## ANNEX TO THE EUROPEAN SEARCH REPORT
## ON EUROPEAN PATENT APPLICATION NO.

EP 24 21 1763

02-04-2025

| Patent document cited in search report | | Publication date | Patent family member(s) | | Publication date |
|---|---|---|---|---|---|
| US 8631055 | B2 | 14-01-2014 | CN | 102754078 A | 24-10-2012 |
| | | | EP | 2483777 A2 | 08-08-2012 |
| | | | JP | 2013506917 A | 28-02-2013 |
| | | | KR | 20120098628 A | 05-09-2012 |
| | | | US | 2011078222 A1 | 31-03-2011 |
| | | | US | 2014095561 A1 | 03-04-2014 |
| | | | WO | 2011041269 A2 | 07-04-2011 |
| US 2024111439 | A1 | 04-04-2024 | US | 11966597 B1 | 23-04-2024 |
| | | | US | 2024231648 A1 | 11-07-2024 |
| | | | WO | 2024073531 A1 | 04-04-2024 |
| US 9118345 | B2 | 25-08-2015 | US | 2014101485 A1 | 10-04-2014 |
| | | | WO | 2014055511 A1 | 10-04-2014 |
| WO 2016186563 | A1 | 24-11-2016 | CA | 2986555 A1 | 24-11-2016 |
| | | | CN | 107925418 A | 17-04-2018 |
| | | | EP | 3304746 A1 | 11-04-2018 |
| | | | JP | 7010548 B2 | 26-01-2022 |
| | | | JP | 2018522457 A | 09-08-2018 |
| | | | JP | 2022031735 A | 22-02-2022 |
| | | | KR | 20180019597 A | 26-02-2018 |
| | | | US | 2018138921 A1 | 17-05-2018 |
| | | | US | 2020044663 A1 | 06-02-2020 |
| | | | WO | 2016186563 A1 | 24-11-2016 |

EPO FORM P0459